(19) Europäisches Patentamt
European Patent Office
Office européen des brevets

(11) EP 3 179 517 B1

(12) **EUROPEAN PATENT SPECIFICATION**

(45) Date of publication and mention of the grant of the patent:
**08.01.2020 Bulletin 2020/02**

(21) Application number: **15845490.0**

(22) Date of filing: **18.09.2015**

(51) Int Cl.:
***H01L 51/10*** *(2006.01)* ***H01L 29/786*** *(2006.01)*
***H01L 21/20*** *(2006.01)* ***H01L 21/336*** *(2006.01)*

(86) International application number:
**PCT/JP2015/076659**

(87) International publication number:
**WO 2016/047587 (31.03.2016 Gazette 2016/13)**

(54) **ORGANIC FIELD EFFECT TRANSISTOR AND METHOD FOR PRODUCING ORGANIC SEMICONDUCTOR CRYSTAL**

ORGANISCHER FELDEFFEKTTRANSISTOR UND VERFAHREN ZUR HERSTELLUNG EINES ORGANISCHEN HALBLEITERKRISTALLS

TRANSISTOR ORGANIQUE À EFFET DE CHAMP ET PROCÉDÉ DE PRODUCTION DE CRISTAL SEMICONDUCTEUR ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.09.2014 JP 2014194675**
**02.04.2015 JP 2015075612**

(43) Date of publication of application:
**14.06.2017 Bulletin 2017/24**

(73) Proprietor: **Fujifilm Corporation**
**Minato-ku**
**Tokyo 106-8620 (JP)**

(72) Inventor: **NIORI Teruki**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 737 027** **EP-A1- 2 197 033**
**JP-A- 2009 177 135** **JP-A- 2009 177 136**
**JP-A- 2009 543 323** **JP-A- 2014 146 637**

- **HONG F ET AL: "Preparation of highly oriented copper phthalocyanine film by molecular templating effects for organic field-effect transistor", ORGANIC ELECTRONICS, ELSEVIER, AMSTERDAM, NL, vol. 10, no. 6, 31 May 2009 (2009-05-31), pages 1097-1101, XP026348792, ISSN: 1566-1199 [retrieved on 2009-05-31]**
- **DO HWAN KIM ET AL: "Liquid-Crystalline Semiconducting Copolymers with Intramolecular Donor?Acceptor Building Blocks for High-Stability Polymer Transistors", JOURNAL OF THE AMERICAN CHEMICAL SOCIETY, vol. 131, no. 17, 6 May 2009 (2009-05-06), pages 6124-6132, XP055384785, US ISSN: 0002-7863, DOI: 10.1021/ja8095569**
- **MCMULLOCH I ET AL: "Polymerisable liquid crystalline organic semiconductors and their fabrication in organic field effect transistors", JOURNAL OF MATERIALS CHEMISTRY, ROYAL SOCIETY OF CHEMISTRY, GB, vol. 13, 21 August 2003 (2003-08-21), pages 2436-2444, XP002327381, ISSN: 0959-9428, DOI: 10.1039/B307764K**
- **IAIN MCCULLOCH ET AL: "Liquid-crystalline semiconducting polymers with high charge-carrier mobility", NATURE MATERIALS, vol. 5, no. 4, 19 March 2006 (2006-03-19), pages 328-333, XP055009146, ISSN: 1476-1122, DOI: 10.1038/nmat1612**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 179 517 B1

## Description

BACKGROUND OF THE INVENTION

1. Field of the Invention

The present invention relates to an organic field-effect transistor, a method for manufacturing an organic semiconductor crystal, and an organic semiconductor element.

2. Description of the Related Art

In order to achieve high mobility in an organic field-effect transistor, organic semiconductor crystals having a monocrystalline structure need to be formed in directions of both of the source and drain electrodes. As a method for aligning an organic semiconductor compound, a method using a liquid crystal compound as described in JP2004-31458A and WO2005/043639A is known.

SUMMARY OF THE INVENTION

In the method described in JP2004-31458A, by using a solvent capable of aligning a liquid crystal compound, an organic semiconductor compound as a mixture is aligned. However, because an organic semiconductor and a liquid crystal compound are uniformly mixed together, in order to bury hole carriers under the organic semiconductor, the liquid crystal compound functioning as a carrier trap should be removed. The removal step needs to be performed under a special environment such as an environment with a reduced pressure or a high-temperature sublimation environment, and it is extremely difficult to reliably remove the liquid crystal compound.

In the method described in WO2005/043639A, an organic semiconductor compound is aligned using self-alignment properties thereof in a liquid crystal state. However, a non-liquid crystal organic semiconductor and an organic compound need to be mixed together such that the compound is aligned with maintaining liquid crystallinity, and then the organic compound needs to be removed. That is, the compound to be used is limited, a special environment needs to be created to remove the organic compound, and impurities need to be reliably removed.

EP 2 197 033 A1 an organic thin film transistor that is superior in stability in the atmosphere and that has a high operation speed. The organic thin film transistor according to the present invention includes three kinds of terminals consisting of a gate electrode, a source electrode, and a drain electrode, an insulator layer that insulates the gate electrode from the source electrode and from the drain electrode, and an organic semiconductor layer; the terminals, the insulator layer, and the organic semiconductor layer being disposed on a substrate; the organic thin film transistor controlling a source-to-drain electric current by a voltage applied to the gate electrode, and the organic thin film transistor is characterized by further including a crystallinity control layer that is formed from a crystalline compound that controls crystallinity of the organic semiconductor layer, and is characterized in that the organic semiconductor layer is formed on the crystallinity control layer and contains a compound having heterocyclic groups or a compound having a quinone structure. The organic thin film light-emitting transistor according to the present invention is characterized in that either one of the source electrode and the drain electrode of the organic thin film transistor is formed of a hole-injecting electrode, and the other electrode is formed of an electron-injecting electrode.

Organic Electronics 10 (2009) 1097-1101 describes the preparation of highly oriented copper phthalocyanine film by molecular templating effects for organic field-effect transistor.

EP 1 737 027 A1a method of manufacturing a field effect transistor of the present invention includes: applying a coating liquid 20 containing a solvent 13 as well as first and second organic molecules 11 and 12 that have been dissolved in the solvent 13; and forming a first layer and a second layer by removing the solvent 13 contained in the coating liquid 20 that has been applied. The first layer contains the first organic molecules 11 as its main component. The second layer adjoins the first layer and contains the second organic molecules 12 as its main component. The first organic molecules 11 are a semiconductor material or a precursor of a semiconductor material. The second organic molecules 12 are an insulator material or a precursor of an insulator material. The first organic molecules 11 and the second organic molecules 12 are not compatible with each other.

J. Am. Chem. Soc. 2009, 131, 6124-6132 describes liquid-crystalline semiconducting copolymers with intramolecular donor-acceptor building blocks for high-stability polymer transistors.

J. Mater. Chem., 2003, 13, 2436-2444 describes polymerisable liquid crystalline organic semiconductors and their fabrication in organic field effect transistors.

Nature Mater., 2006, 5, 328-333 describes liquid-crystalline semiconducting polymers with high charge-carrier mobility.

An object of the present invention is to provide an organic field-effect transistor from which a liquid crystal

compound used for aligning an organic semiconductor does not need to be removed and which has excellent mobility, an organic semiconductor element, and a method for manufacturing an organic semiconductor crystal used in the organic field-effect transistor and the organic semiconductor element.

The aforementioned object of the present invention was achieved by means described in the following <1>, <4>, or <6>. Preferred embodiments are also described below in <2>, <3> and <5>.

<1> An organic field-effect transistor comprising a first layer which consists of an organic semiconductor compound and a second layer which is adjacent to the first layer and consists of a liquid crystal compound, in which an organic semiconductor monocrystal in the first layer has a size of equal to or greater than 100 $\mu m \times 100\ \mu m$.

<2> The organic field-effect transistor according to <1>, in which a ratio of a thickness of the first layer to a total thickness of the first layer and the second layer is equal to or less than 50%.

<3> The organic field-effect transistor according to <1> or <2>, in which the liquid crystal compound contained in the second layer is polymerized.

<4> A method for manufacturing an organic semiconductor crystal, comprising a coating step of coating a substrate with a composition containing an organic semiconductor compound, a liquid crystal compound, and an organic solvent such that an organic film is prepared, a heating step of heating the organic film until the organic film enters an isotropic phase, and a phase separation step of causing an organic semiconductor compound layer and a liquid crystal compound layer to undergo lamellar phase separation in a direction parallel to a surface of the substrate by cooling the organic film such that the organic semiconductor compound is crystallized, in this order.

<5> The method for manufacturing an organic semiconductor crystal according to <4>, further comprising a polymerization step of polymerizing the liquid crystal compound layer such that the layer is fixed.

<6> The organic field-effect transistor according to any one of <1> to <3>, further comprising: a gate electrode, a source electrode, a drain electrode, a gate insulating layer insulating the source electrode and the drain electrode from the gate electrode, and a substrate supporting these.

According to the present invention, it is possible to provide an organic field-effect transistor from which a liquid crystal compound used for aligning an organic semiconductor does not need to be removed and which has excellent mobility, an organic semiconductor element, and a method for manufacturing an organic semiconductor crystal used in the organic field-effect transistor and the organic semiconductor element.

## BRIEF DESCRIPTION OF THE DRAWINGS

Fig. 1 is a schematic cross-sectional view of an aspect of an organic semiconductor element of the present invention.

Fig. 2 is a schematic cross-sectional view of another aspect of the organic semiconductor element of the present invention.

Fig. 3 is a polarizing micrograph of an organic semiconductor crystal of the present invention prepared in an example.

Fig. 4 is a polarizing micrograph of an organic semiconductor crystal prepared in a comparative example.

Fig. 5 is a graph showing a material distribution in a thickness direction of a sample S1 prepared in an example.

## DESCRIPTION OF THE PREFERRED EMBODIMENTS

Hereinafter, the contents of the present invention will be specifically described. The constituents in the following description will be explained based on typical embodiments of the present invention, but the present invention is not limited to the embodiments. In the specification of the present application, "to" is used to mean that the numerical values listed before and after "to" are a lower limit and an upper limit respectively. Furthermore, in the present invention, an organic EL element refers to an organic electroluminescence element.

In the present specification, in a case where there is no description regarding whether a group (atomic group) is substituted or unsubstituted, the group includes both of a group having a substituent and a group not having a substituent. For example, an "alkyl group" includes not only an alkyl group not having a substituent (unsubstituted alkyl group) but also an alkyl group having a substituent (substituted alkyl group).

In the present specification, in some cases, a chemical structural formula is described as a simplified structural formula in which a hydrogen atom is omitted.

In the present specification, "(meth)acrylate" represents acrylate and methacrylate, "(meth)acryl" represents acryl and methacryl, and "(meth)acryloyl" represents acryloyl and methacryloyl.

In the present invention, "at least one kind selected from the group consisting of al to a3" or the like is simply referred to as a "component A" or the like.

In the present invention, "% by mass" and "% by weight" have the same definition, and "part by mass" and "part by weight" have the same definition.

In the present invention, a combination of preferred aspects is a more preferred aspect.

(Organic field-effect transistor)

An organic field-effect transistor used in the present invention has a first layer which consists of an organic semiconductor compound (hereinafter, simply referred to as an "organic semiconductor" as well) and a second layer which is adjacent to the first layer and consists of a liquid crystal compound, in which an organic semiconductor crystal in the first layer has a size of equal to or greater than 100 μm × 100 μm.

According to the aforementioned aspect, it is possible to provide an organic field-effect transistor, from which a liquid crystal compound used for aligning an organic semiconductor does not need to be removed and which has excellent mobility, an organic semiconductor element, and a method for manufacturing an organic semiconductor crystal used in the organic field-effect transistor and the organic semiconductor element.

The detailed mechanism that brings about the aforementioned effect is unclear, but is assumed to be as below. Presumably, by mixing and heating an organic semiconductor and a liquid crystal compound together such that they are homogenized and then cooling the resultant such that phase separation occurs, the organic semiconductor may be crystallized while being localized on the surface of a liquid crystal as the liquid crystal compound is aligned.

At the time of crystallization described above, the organic semiconductor crystal can be aligned by using an anchoring force of the liquid crystal compound, and the size of the organic semiconductor crystal surprisingly increases.

Therefore, a highly aligned large-sized organic semiconductor monocrystal can be formed within a short period of time at a low temperature, the type of organic semiconductor is not limited, and the liquid crystal compound does not need to be removed. Therefore, a removal facility or an assurance on removal is not necessary, and phase separation that occurs at a temperature facilitating control management is utilized. Consequently, the organic semiconductor crystal can be manufactured in an environment that is controlled in a simple manner.

<First layer>

The first layer is a layer which exhibits semiconductivity and enables carrier accumulation. The first layer may be a layer containing an organic semiconductor compound, and a compound having liquid crystalline properties as well is also regarded as a semiconductor. That is, a compound included in organic semiconductor compounds is not included in liquid crystal compounds. The organic semiconductor is not particularly limited, and examples thereof include an organic polymer and a derivative thereof, a low-molecular weight compound, and the like. In the present invention, a low-molecular weight compound means a compound other than an organic polymer and a derivative thereof. That is, the low-molecular weight compound refers to a compound not having a repeating unit. As long as the low-molecular weight compound is a compound described above, the molecular weight thereof is not particularly limited. The molecular weight of the low-molecular weight compound is preferably 100 to 2,000, and more preferably 100 to 1,000. From the viewpoint of crystallization, the low-molecular weight compound is more preferable.

The size of the organic semiconductor crystal in the first layer is equal to or greater than 100 μm × 100 μm, preferably equal to or greater than 200 μm × 200 μm, and even more preferably equal to or greater than 500 μm × 500 μm.

The upper limit of the size of the organic semiconductor crystal in the first layer is not particularly limited, but is preferably equal to or less than 5 mm × 5 mm.

The size of the organic semiconductor crystal can be measured by observing the crystal in a direction perpendicular to a plane that a surface of the organic semiconductor forms by using a polarizing microscope.

The thickness of the first layer is preferably 10 to 100 nm, more preferably 15 to 80 nm, and even more preferably 20 to 60 nm.

The proportion of the organic semiconductor constituting the first layer is preferably equal to or greater than 99% by mass, and more preferably 100% by mass.

Examples of the low-molecular weight compound include condensed polycyclic aromatic compounds like acene such as naphthacene, pentacene (2,3,6,7-dibenzoanthracene), hexacene, heptacene, dibenzopentacene, or tetrabenzopentacene, anthradithiophene, pyrene, benzopyrene, dibenzopyrene, chrysene, perylene, coronene, terylene, ovalene, quoterylene, circumanthracene, derivatives obtained by substituting some of the carbon atoms of the above compounds with an atom of N, S, O, and the like, derivatives obtained by substituting at least one hydrogen atom bonded to the carbon atoms with a functional group such as a carbonyl group (a dioxaanthanthrene-based compound containing peri-xanthenoxanthene and a derivative thereof, triphenodioxanzine, triphenodithiazine, hexacene-6,15-quinone, and the like), derivatives obtained by substituting the hydrogen atom with other functional groups, and the like.

The examples also include metal phthalocyanine represented by copper phthalocyanine, tetrathiapentalene and a derivative thereof, ring-fused tetracarboxylic acid diimide like naphthalene carboxylic acid diimide such as naphthalene-1,4,5,8-tetracarboxylic acid diimide, N,N'-bis(4-trifluoromethylbenzyl)naphthalene-1,4,5,8-tetracarboxylic acid diimide, N,N'-bis(1H,1H-perfluorooctyl), N,N'-bis(1H,1H-perfluorobutyl), a N,N'-dioctylnaphthalene-1,4,5,8-tetracarboxylic acid diimide derivative, or naphthalene-2,3,6,7-tetracarboxylic acid diimide and anthracene tetracarboxylic acid diimide such as anthracene-2,3,6,7-tetracarboxylic acid diimide, fullerene such as C60, C70, C76, C78, or C84 and a derivative thereof, carbon nanotubes such as SWNT, a dye such as a merocyanine dye or a hemicyanine dye and a derivative thereof, and the like.

The examples also include polyanthracene, triphenylene, and quinacridone.

Examples of the low-molecular weight compound also include 4,4'-biphenyldithiol (BPDT), 4,4'-diisocyanobiphenyl, 4,4'-diisocyano-p-terphenyl, 2,5-bis(5'-thioacetyl-2'-thiophenyl)thiophene, 2,5-bis(5'-thioacetoxyl-2'-thiophenyl)thiophene, 4,4'-diisocyanophenyl, benzidine(biphenyl-4,4'-diamine), tetracyanoquinodimethane (TCNQ), tetrathiafulvalene (TTF) and a derivative thereof, a charge transfer complex represented by a tetrathiafulvalene (TTF)-TCNQ complex, a bisethylenetetrathiafluvalene (BEDTTTF)-perchloric acid complex, a BEDTTTF-iodine complex, or a TCNQ-iodine complex, biphenyl-4,4'-dicarboxylic acid, 1,4-di(4-thiophenylacetylenyl)-2-ethylbenzene, 1,4-di(4-isocyanophenylacetylenyl)-2-ethylbenzene, 1 ,4-di(4-thiophenylethynyl)-2-ethylbenzene, 2,2"-dihydroxy-1,1':4',1"-terphenyl, 4,4'-biphenyldiethanol, 4,4'-biphenyldiole, 4,4'-biphenyldiisocyanate, 1,4-diacetynylbenzene, diethylbiphenyl-4,4'-dicarboxylate, benzo[1,2-c;3,4-c';5,6-c"]tris[1,2]dithiol-1,4,7-trithione, $\alpha$-sexithiophene, tetrathiatetracene, tetraselenotetracene, tetratellurutetracene, poly(3-alkylthiophene), poly(3-thiophene-$\beta$-ethane sulfonic acid), poly(N-alkylpyrrole), poly(3-alkylpyrrole), poly(3,4-dialkylpyrrole), poly(2,2'-thienylpyrrole), and poly(dibenzothiophenesulfide).

The organic semiconductor is preferably a low-molecular weight compound and particularly preferably a condensed polycyclic aromatic compound. The condensed polycyclic aromatic compound is extremely effective for improving carrier mobility and durability and has an excellent threshold voltage reduction effect.

As the condensed polycyclic aromatic compound, a compound represented by Formula 1, acene represented by any one of Formulae A1 to A4, and a compound represented by any one of the following Formulae C to H, J to N, and P to T are preferable, and a compound represented by any one of the following Formulae C to H, J to N, and P to T is more preferable.

The condensed polycyclic aromatic compound is preferably a compound represented by Formula 1.

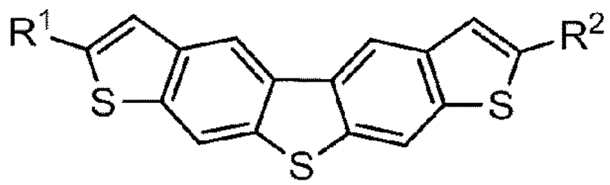

(1)

In Formula 1, $R^1$ and $R^2$ each independently have 3 to 30 carbon atoms in total and represent an unsubstituted linear alkyl group having an even number of carbon atoms within a range of 6 to 10 carbon atoms, an unsubstituted alkyl group having an odd number of carbon atoms within a range of 3 to 15 carbon atoms, a substituted linear alkyl group having 3 to 15 carbon atoms, or a substituted or unsubstituted branched alkyl group having 3 to 18 carbon atoms. The aromatic portion in Formula 1 may be substituted with a halogen atom.

First, a preferred aspect of the structure of the compound represented by Formula 1 will be described.

In Formula 1, $R^1$ and $R^2$ each independently have 3 to 30 carbon atoms in total and represent an unsubstituted alkyl group having an even number of carbon atoms within a range of 6 to 10 carbon atoms, an unsubstituted linear alkyl group having an odd number of carbon atoms within a range of 3 to 15 carbon atoms, a substituted linear alkyl group having 3 to 15 carbon atoms, or a substituted or unsubstituted branched alkyl group having 3 to 18 carbon atoms.

The unsubstituted linear alkyl group having an even number of carbon atoms within a range of 6 to 10 carbon atoms that is represented by $R^1$ and $R^2$ is more preferably a linear alkyl group having 6 or 8 carbon atoms, and particularly preferably a linear alkyl group having 6 carbon atoms. It is preferable that the alkyl group is preferably a long-chain alkyl group having carbon atoms within the above range and particularly preferably a long-chain linear alkyl group, because then the linearity of the molecule is improved, and the carrier mobility can be improved.

The unsubstituted linear alkyl group having an odd number of carbon atoms within a range of 3 to 15 carbon atoms that is represented by $R^1$ and $R^2$ is preferably an unsubstituted linear alkyl group having an odd number of carbon atoms within a range of 5 to 15 carbon atoms, more preferably an unsubstituted linear alkyl group having an odd number of carbon atoms within a range of 7 to 13 carbon atoms, and particularly preferably an unsubstituted linear alkyl group having 9 or 11 carbon atoms.

It is preferable that $R^1$ and $R^2$ preferably each represent a linear alkyl group, because then the linearity of the molecule is improved, and the carrier mobility can be improved. In contrast, from the viewpoint of improving the solubility of the compound in an organic solvent, $R^1$ and $R^2$ may each represent a branched alkyl group.

In a case where $R^1$ and $R^2$ each represent a substituted alkyl group having 3 to 15 carbon atoms or a substituted

branched alkyl group having 3 to 18 carbon atoms, the substituent is not particularly limited. Examples of the substituent include a halogen atom, an alkenyl group (including an ethenyl group, a 1-pentenyl group, a 1-heptanyl group, a cycloalkenyl group, a bicycloalkenyl group, and the like), an alkynyl group (including a 1-pentynyl group, a trimethylsilyl ethenyl group, a triethylsilyl ethenyl group, a tri-i-propylsilyl ethenyl group, a 2-p-propylphenyl ethenyl group, and the like), an aryl group (including an aryl group having 6 to 20 carbon atoms such as a phenyl group, a naphthyl group, a p-pentylphenyl group, a 3,4-dipentylphenyl group, a p-heptoxyphenyl group, or a 3,4-diheptoxyphenyl group, and the like), a heterocyclic group (may be referred to as a hetero ring group, including a 2-hexylfuranyl group and the like), a cyano group, a hydroxyl group, a nitro group, an acyl group (including a hexanoyl group, a benzoyl group, and the like), an alkoxy group (including a butoxy group and the like), an aryloxy group (including a phenoxy group and the like), a silyloxy group, a heterocyclic oxy group, an acyloxy group, a carbamoyloxy group, an amino group (including an anilino group), an acylamino group, an aminocarbonyl amino group (including a ureido group), an alkoxy- and aryloxycarbonylamino group, an alkyl- and arylsulfonylamino group, a mercapto group, an alkyl- and arylthio group (including a methylthio group, an octylthio group, and the like), a heterocyclic thio group, a sulfamoyl group, a sulfo group, an alkyl- and arylsulfinyl group, an alkyl- and arylsulfonyl group, an alkyl- and aryloxycarbonyl group, a carbamoyl group, an aryl- and heterocyclic azo group, an imide group, a phosphino group, a phosphinyl group, a phosphinyloxy group, a phosphinylamino group, a phosphono group, a silyl group (such s ditrimethylsiloxymethyl butoxy group), a hydrazino group, a ureido group, a boronic acid group ($-B(OH)_2$), a phosphato group ($-OPO(OH)_2$), a sulfato group ($-OSO_3H$), and other known substituents.

These substituents may further have the above substituents.

Among these, as adoptable substituents, a halogen atom, an aryl group, an alkenyl group, an alkynyl group, a heterocyclic group, an alkoxy group, an alkylthio group, and an aryloxy group are preferable, and a fluorine atom, an aryl group having 6 to 20 carbon atoms, an alkenyl group having 2 to 12 carbon atoms (preferably a 1-alkenyl group), an alkynyl group having 2 to 12 carbon atoms, an alkoxy group having 1 to 11 carbon atoms, a heterocyclic group having 5 to 12 carbon atoms, and an alkylthio group having 1 to 12 carbon atoms are more preferable.

In a case where $R^1$ and $R^2$ each represent an alkyl group substituted with a fluorine atom, some of the hydrogen atoms of the alkyl group may be substituted with a fluorine atom, or all of the hydrogen atoms may be substituted such that a perfluoroalkyl group is formed.

Here, it is preferable that $R^1$ and $R^2$ each represent an unsubstituted linear alkyl group or a branched alkyl group.

In a case where $R^1$ and $R^2$ each represent a substituted linear alkyl group having 3 to 15 carbon atoms, the alkyl group is preferably a substituted linear alkyl group having 3 to 13 carbon atoms, more preferably a substituted linear alkyl group having 3 to 11 carbon atoms, particularly preferably a substituted linear alkyl group having 5 to 11 carbon atoms, and more particularly preferably a substituted linear alkyl group having 7 to 11 carbon atoms.

In a case where $R^1$ and $R^2$ each represent a substituted branched alkyl group having 3 to 18 carbon atoms, the alkyl group is preferably a substituted branched alkyl group having 3 to 15 carbon atoms, more preferably a substituted branched alkyl group having 3 to 13 carbon atoms, particularly preferably a substituted branched alkyl group having 3 to 11 carbon atoms, and more particularly preferably a substituted branched alkyl group having 7 to 11 carbon atoms.

In a case where $R^1$ and $R^2$ each represent a linear or branched alkyl group having a substituent, $-CH_2-$ groups in the linear alkyl group that are not adjacent to each other, $-CH_2-$groups in the branched alkyl group that are not adjacent to each other, a trivalent tertiary carbon atom linking group, or a tetravalent quaternary carbon atom linking group may be each independently substituted with other atomic linking groups. In this case, examples of other atomic linking groups include -O-, -S-, -CO-, -COO-, -OCO-, -COS-, -SCO-, -NRCO-, -CONR- (R represents a hydrogen atom or an alkyl group having 1 to 6 carbon atoms), and the like.

Here, it is preferable that, in $R^1$ and $R^2$, $-CH_2-$ groups in the linear alkyl group that are not adjacent to each other, $-CH_2-$ groups in the branched alkyl group that are not adjacent to each other, a trivalent tertiary carbon atom linking group, or a tetravalent quaternary carbon atom linking group is not substituted with other atomic linking groups.

$R^1$ and $R^2$ each independently preferably has 3 to 30 carbon atoms in total, more preferably has 7 to 30 carbon atoms in total, even more preferably 7 to 20 carbon atoms, particularly preferably has 7 to 15 carbon atoms in total, more particularly preferably has 7 to 11 carbon atoms in total, and most preferably has 9 to 11 carbon atoms in total. In a case where the total number of carbon atoms that $R^1$ and $R^2$ each independently have is equal to or greater than the lower limit of the above range, the carrier mobility is improved. In a case where the total number of carbon atoms of $R^1$ and $R^2$ is equal to or less than the upper limit of the above range, the solubility of the compound in an organic solvent is improved.

The aromatic portion in Formula 1 may be substituted with a halogen atom. The halogen atom is preferably a fluorine atom.

The number of halogen atoms substituting the aromatic portion in Formula 1 is preferably 0 to 6, more preferably 0 to 4, particularly preferably 0 to 2, and most preferably 0.

Specific examples of the compound represented by Formula 1 include the following compounds 1 to 23, but the compound represented by Formula 1 that can be used in the present invention is not limited to the specific examples.

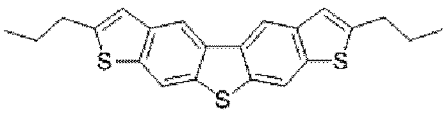

(1)

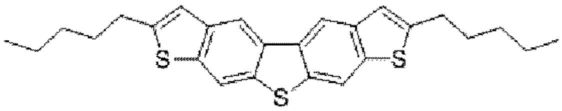

(2)

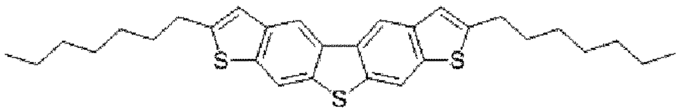

(3)

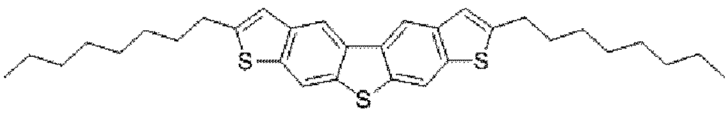

(4)

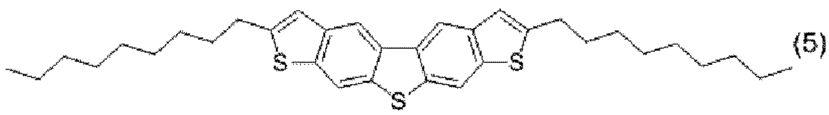

(5)

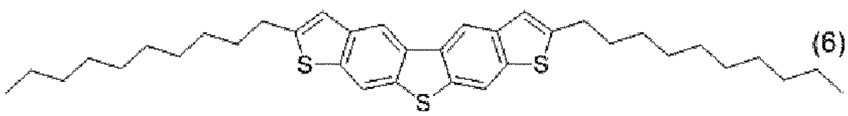

(6)

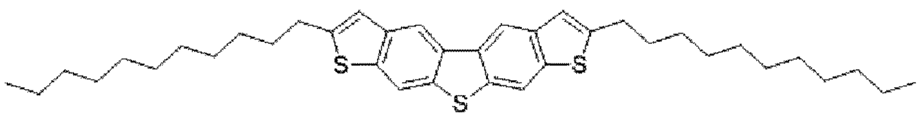

(7)

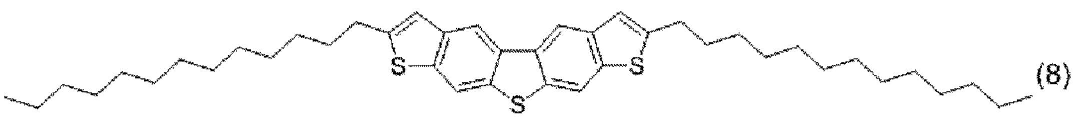

(8)

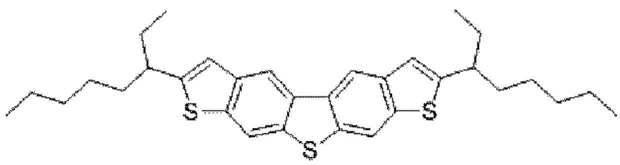

(9)

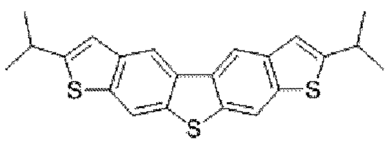

(10)

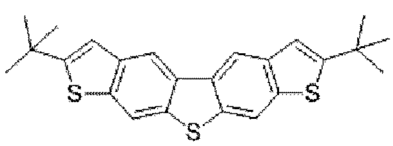

(11)

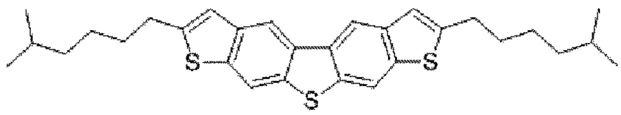

(12)

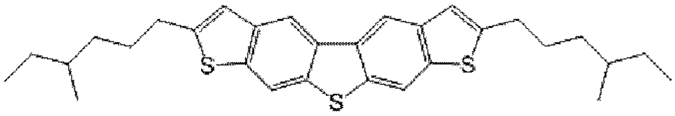

(13)

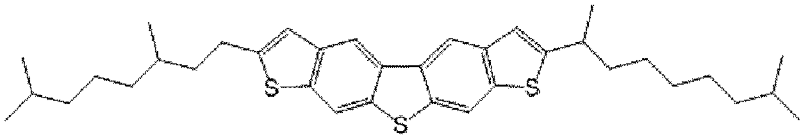

(14)

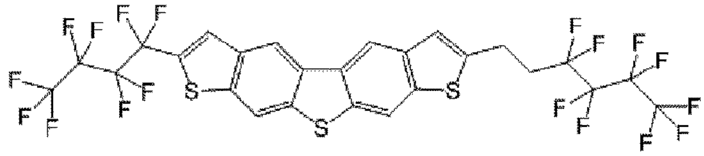

(15)

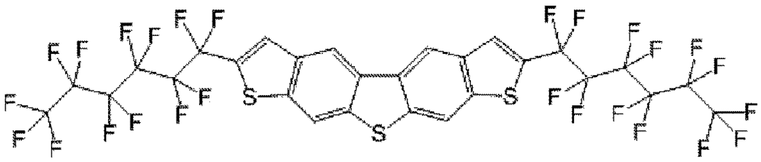

(16)

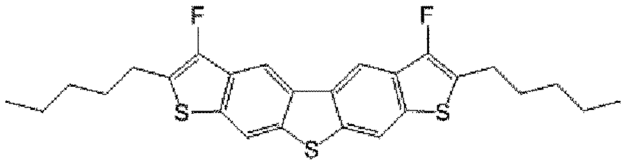

(17)

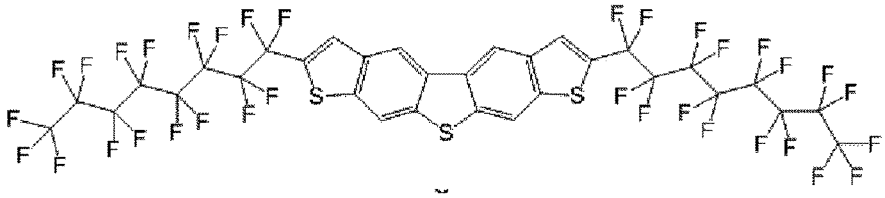

(18)

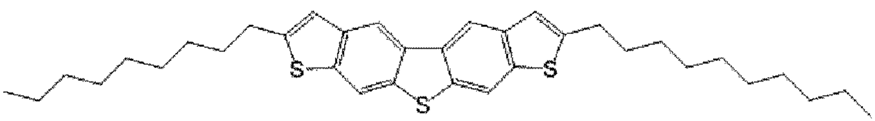

(19)

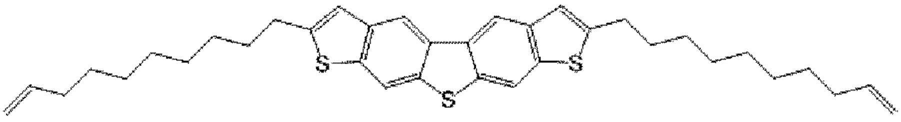

(20)

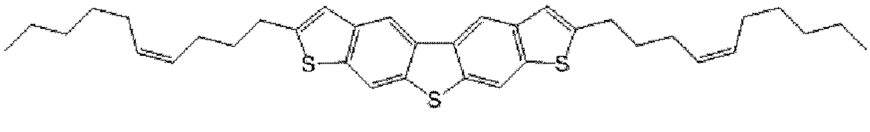

(21)

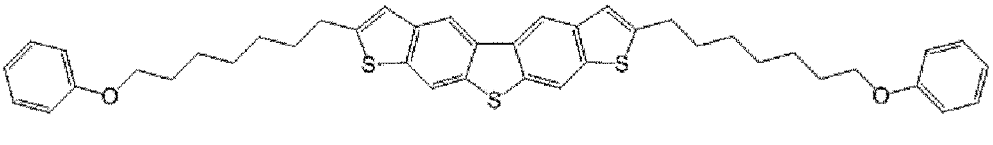

(22)

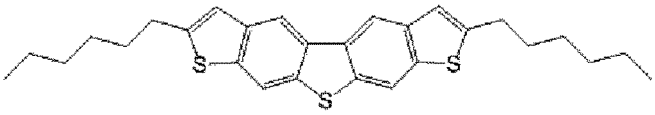

(23)

The acene preferable as the condensed polycyclic aromatic compound is represented by the following Formula A1 or A2.

Formula (A1)

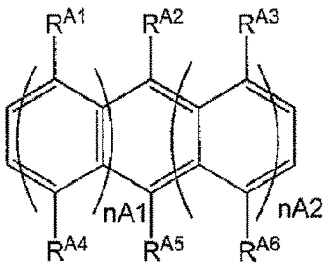

Formula (A2)

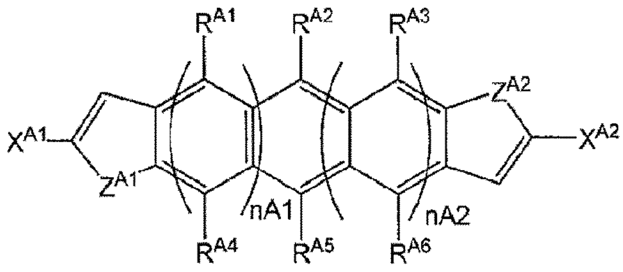

In Formulae $A^1$ and $A^2$, $R^{A1}$ to $R^{A6}$ and $X^{A1}$ and $X^{A2}$ represent a hydrogen atom or a substituent.
$Z^{A1}$ and $Z^{A2}$ represent S, O, Se, or Te.
nA1 and nA2 represent an integer of 0 to 3. Here, there is no case where nA1 and nA2 represent 0 at the same time.
The substituent represented by each of $R^{A1}$ to $R^{A6}$ is not particularly limited, and examples thereof include an alkyl group (for example, methyl, ethyl, propyl, isopropyl, tert-butyl, pentyl, tert-pentyl, hexyl, octyl, tert-octyl, dodecyl, tridecyl, tetradecyl, or pentadecyl), a cycloalkyl group (for example, cyclopentyl or cyclohexyl), an alkenyl group (for example, vinyl, allyl, 1-propenyl, 2-butenyl, 1,3-butadienyl, 2-pentenyl, or isopropenyl), an alkynyl group (for example, ethynyl or propargyl), an aromatic hydrocarbon group (referred to as an aromatic carbon ring group or an aryl group as well, for example, phenyl, p-chlorophenyl, mesityl, tolyl, xylyl, naphthyl, anthryl, azulenyl, acenaphthenyl, fluorenyl, phenanthryl, indenyl, pyrenyl, or biphenylyl), an aromatic heterocyclic group (referred to as a heteroaryl group as well, for example, a pyridyl group, a pyrimidinyl group, a furyl group, a pyrrolyl group, an imidazolyl group, an benzimidazolyl group, a pyrazolyl group, a pyrazinyl group, a triazolyl group (for example, a 1,2,4-triazol-1-yl group or a 1,2,3-triazol-1-yl group), an oxazolyl group, a benzoxazolyl group, a thiazolyl group, an isoxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, a diazacarbazolyl group (a group obtained by substituting one of the carbon atoms constituting a carboline ring of a carbolinyl group with a nitrogen atom), a quinoxalinyl group, a pyridazinyl group, a triazinyl group, a quinazolyl group, an phthalazinyl group, and the like), a heterocyclic group (refers to a heteroaryl ring group or the like as well, for example, a pyrrolidyl group, an imidazolidyl group, a morpholyl group, or an oxazolidyl group), an alkoxy group (for example, methoxy, ethoxy, propyloxy, pentyloxy, hexyloxy, octyloxy, or dodecyloxy), a cycloalkoxy group (for example, cyclopentyloxy or cyclohexyloxy), an aryloxy group (for example, phenoxy or napthyloxy), an alkylthio group (for example, methylthio, ethylthio, propylthio, pentylthio, hexylthio, octylthio, or dodecylthio), a cycloalkylthio group (for example, cyclopentylthio or cyclohexylthio), an arylthio group (for example, phenylthio or naphthylthio), an alkoxycarbonyl group (for example, methylocycarbonyl, ethyloxycarbonyl, butyloxycarbonyl, octyloxycarbonyl, or dodecyloxycarbonyl), an aryloxycarbonyl group (for example, phenyloxycarbonyl or naphthyloxycarbonyl), a sulfamoyl group (for example, aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, or 2-pyridylaminosulfonyl), an acyl group (for example, acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, or pyridylcarbonyl), an acyloxy group (for example, acetyloxy, ethylcarbonyloxy, butylcarbonyloxy, octylcarbonyloxy, dodecylcarbonyloxy, or phenylcarbonyloxy), an amide group (for example, methylcarbonylamino, ethylcarbonylamino, dimethylcarbonylamino, propylcarbonylamino, pentylcarbonylamino, cyclohexylcarbonylamino, 2-ethylhexylcarbonylamino, octylcarbonylamino, dodecylcarbonylamino, phenylcarbonylamino, or naphthylcarbonylamino), a carbamoyl group (for example, aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, or 2-pyridylaminocarbonyl), a uredo group (for example, methylureido, ethylureido, pentylureido, cyclohexylureido, octylureido, dodecylureido, phenylureido, naphthylureido, or 2-pyridylaminouredo), a sulfinyl group (for example, methylsulfinyl, ethylsulfinyl, butylsulfinyl, cyclohexylsulfinyl, 2-ethylhexylsulfinyl, dodecylsulfinyl, phenylsulfinyl, naphthylsulfinyl, or 2-pyridylsulfinyl), an alkylsulfonyl group (for example, methylsulfonyl, ethylsufonyl, butylsulfonyl, cyclohexylsulfonyl, 2-ethylhexylsulfonyl, or dodecylsulfonyl), an arylsulfonyl group (phenylsulfonyl, naphthylsulfonyl, or 2-pyridylsulfonyl), an amino group (for example, amino, ethylamino, dimethylamino, butylamino, cyclopentylamino, 2-ethylhexylamino, dodecylamino, anilino, naphthylamino, or 2-pyridylamino), a halogen atom (for example, a fluorine atom, a chlorine atom, or a bromine atom), a fluorohydrocarbon group (for example, fluoromethyl, trifluoromethyl, pentafluoroethyl, or pentafluorophenyl), a cyano group, a nitro group, a hydroxy group, a mercapto group, a silyl group (for example, trimethylsilyl, triisopropylsilyl, triphenylsilyl, or phenyldiethylsilyl), a group represented by the following Formula SG1 (here, $X^A$ represents Ge or Sn), and the like.

These substituents may further have a plurality of substituents. Examples of the plurality of substituents that the above substituents may have include substituents represented by $R^{A1}$ to $R^{A6}$ described above.

Among the aforementioned acenes, those represented by the following Formula A3 or A4 are preferable.

Formula (A3)

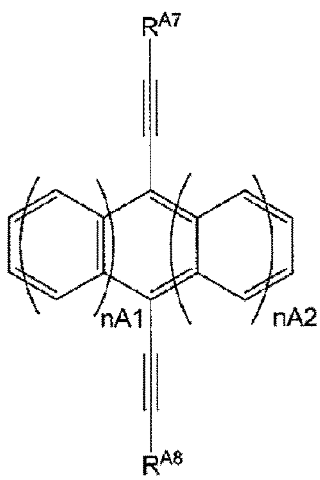

Formula (A4)

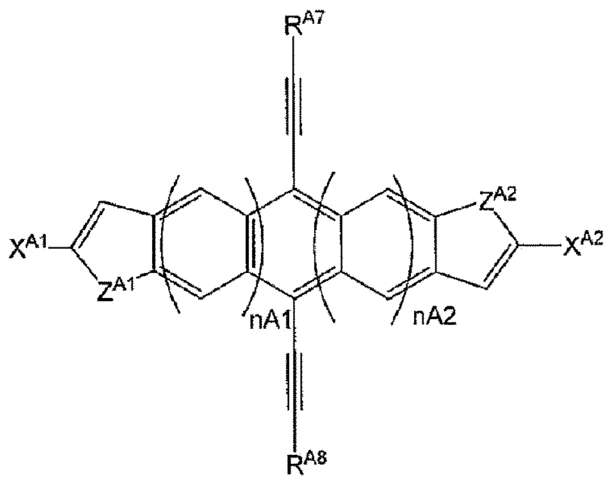

In the formulae, $R^{A7}$, $R^{A8}$, $X^{A1}$, and $X^{A2}$ represent a hydrogen atom or a substituent. $R^{A7}$, $R^{A8}$, $X^{A1}$, and $X^{A2}$ may be the same as or different from each other. As the substituent represented by $R^{A7}$ and $R^{A8}$, those exemplified above as the substituents that can be adopted as $R^{A1}$ to $R^{A6}$ in Formulae A1 and A2 are preferable.

$Z^{A1}$ and $Z^{A2}$ represent S, O, Se, or Te.

nA1 and nA2 represent an integer of 0 to 3. Here, there is no case where nA1 and nA2 represent 0 at the same time.

In Formula A3 or A4, $R^{A7}$ and $R^{A8}$ are preferably represented by the following Formula SG1.

Formula (SG1)

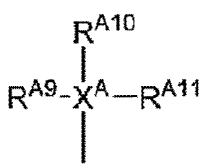

In the formula, $R^{A9}$ to $R^{A11}$ represent a substituent, and $X^A$ represents Si, Ge, or Sn. As the substituent represented by $R^{A9}$ to $R^{A11}$, those exemplified above as the substituents that can be adopted as $R^{A1}$ to $R^{A6}$ in Formulae A1

and A2 are preferable.

Specific examples of the acene represented by Formulae A1 to A4 and the acene derivative will be shown below, but the present invention is not limited thereto.

Compound A1

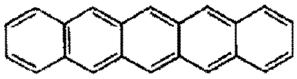

Compound A2

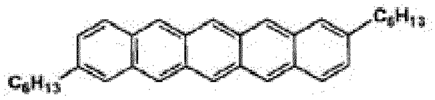

Compound A3

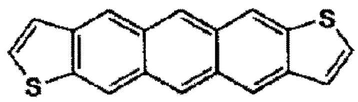

Compound A4

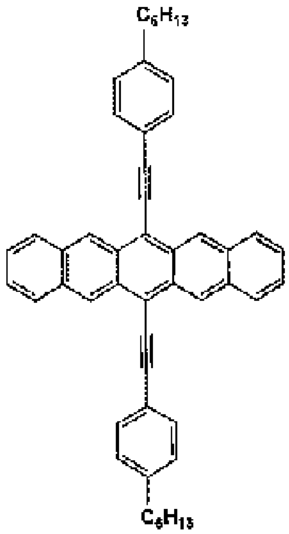

Compound A5

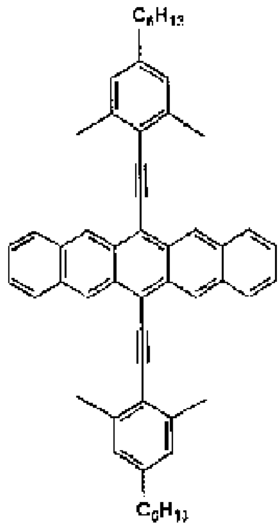

Compound A6

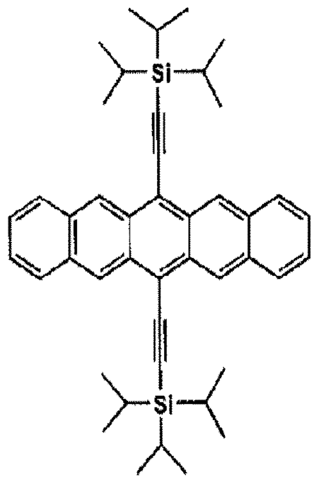

Compound A7

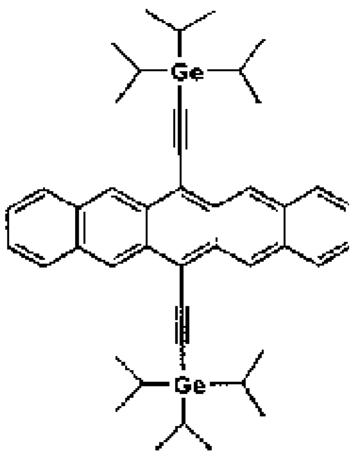

Compound A8

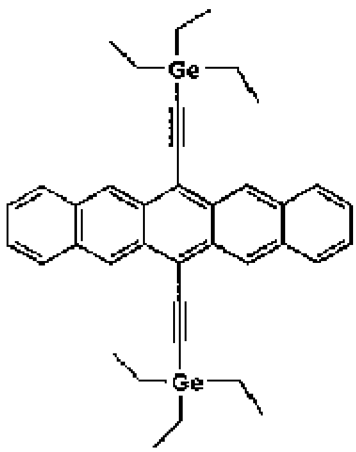

Compound A9

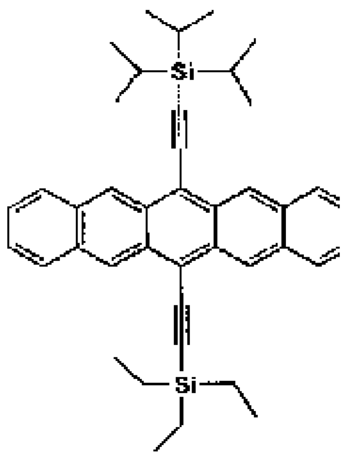

Compound A10

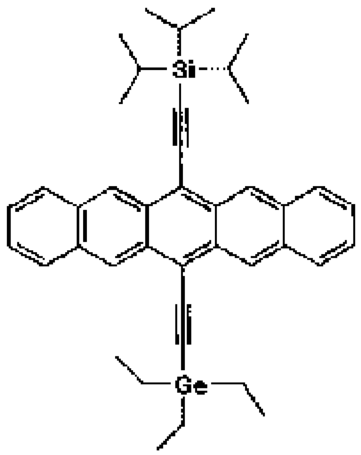

Compound A11

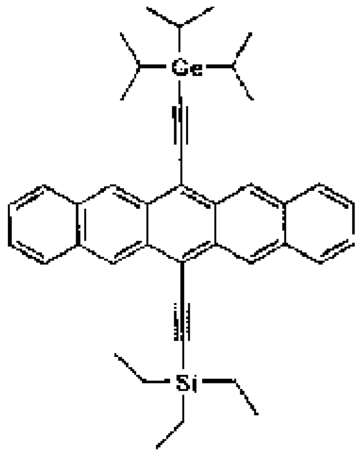

Compound A12

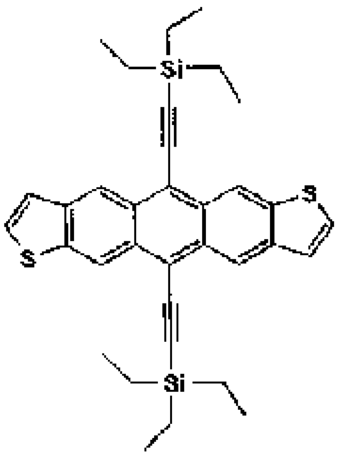

Compound A13

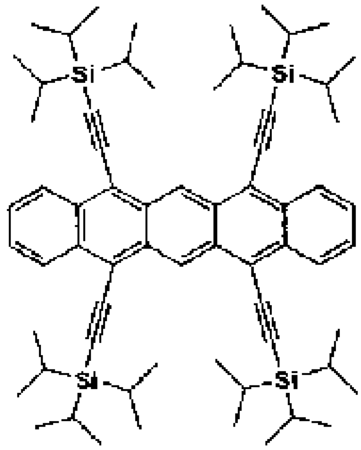

Compound A14

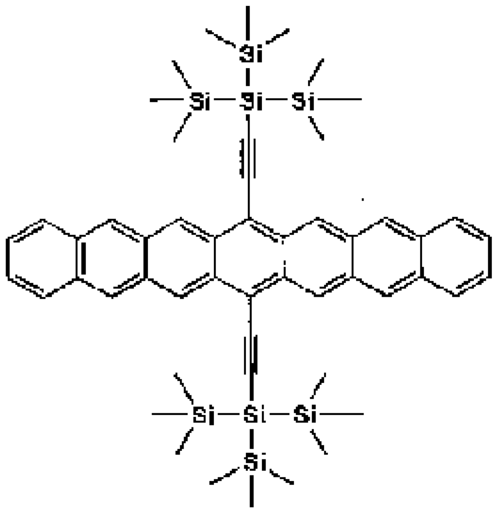

Compound A15

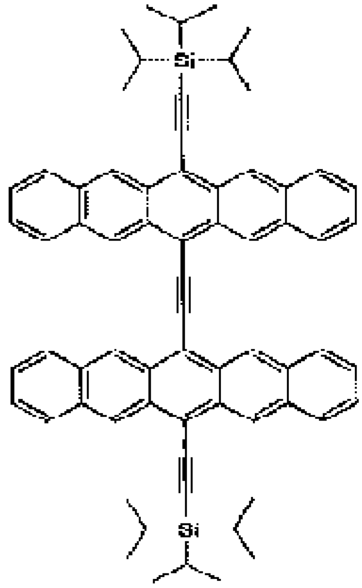

Compound A16

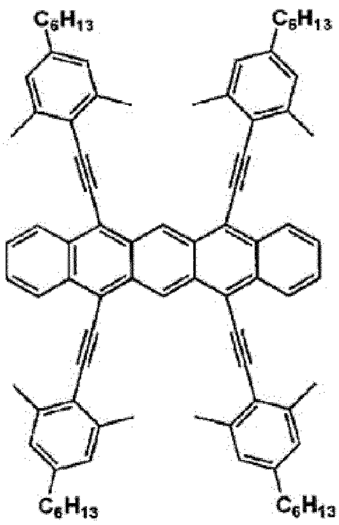

Compound A17

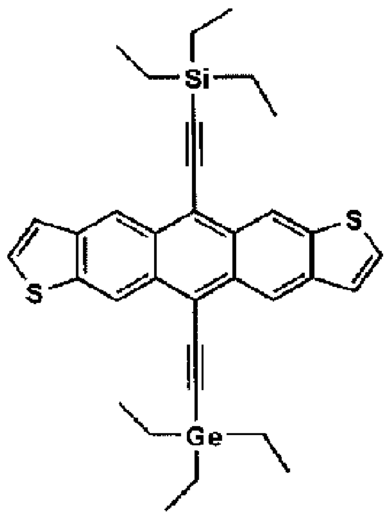

Compound A18

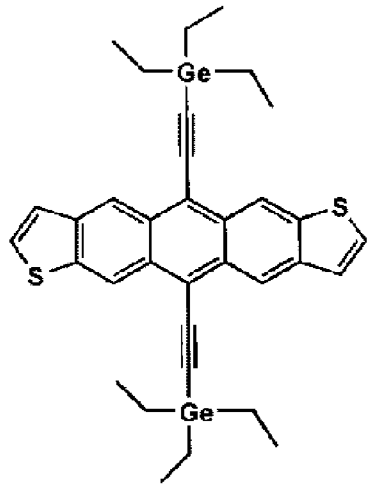

Compound A19

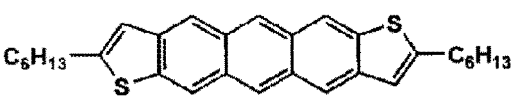

Compound A20

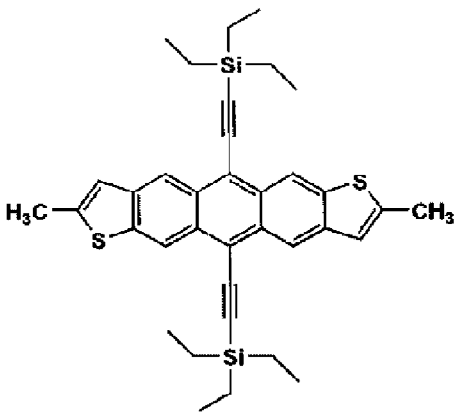

Compound A21

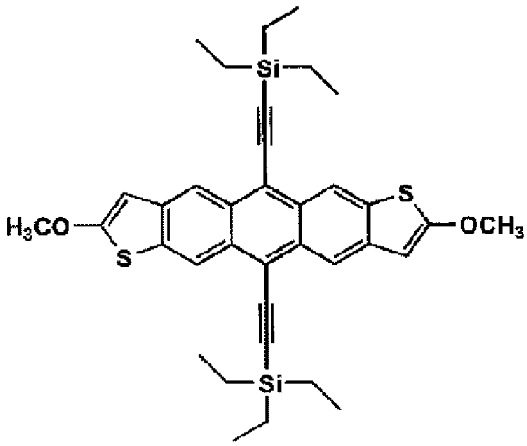

Compound A22

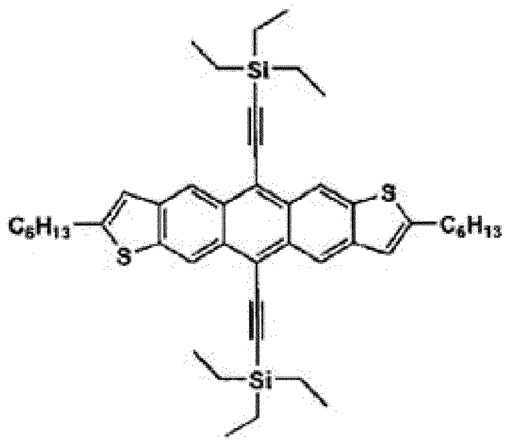

Compound A23

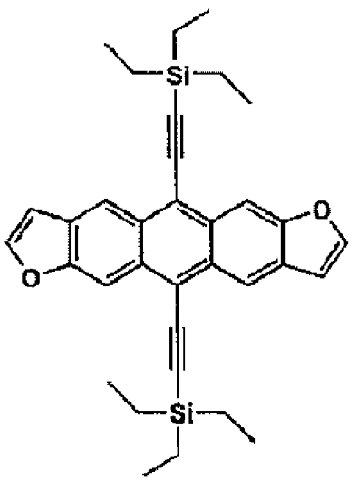

Compound A24

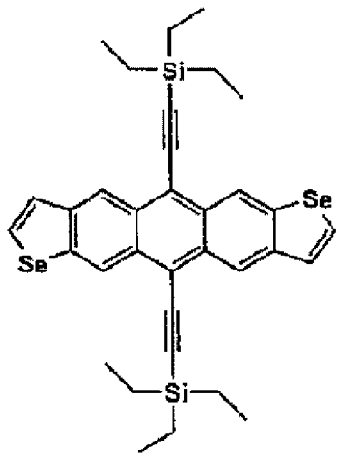

Compound A25

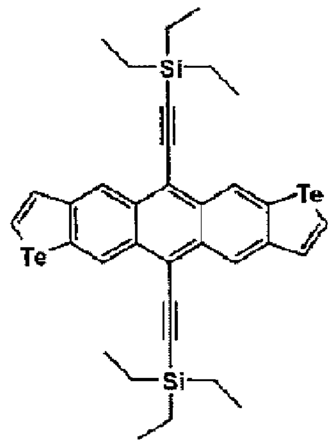

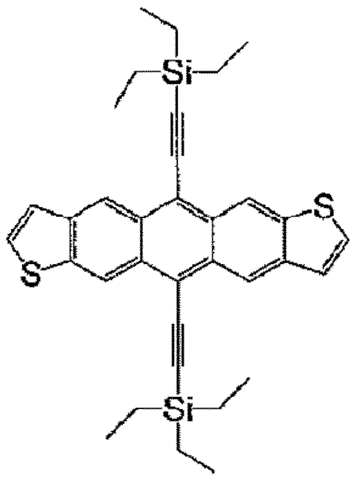

Compound A26

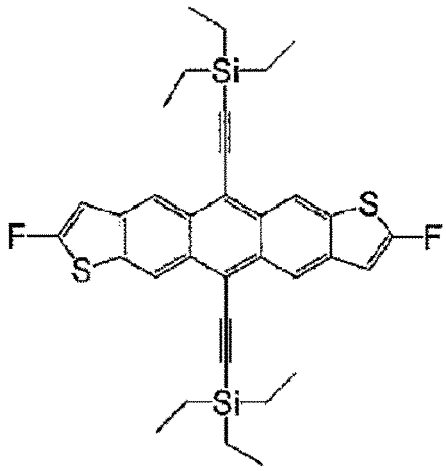

Compound A27

As the condensed polycyclic aromatic compound, the compounds represented by the following Formulae C to H, J to N, and P to T are also preferable.

Formula (C)

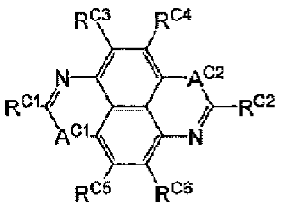

Formula (D)

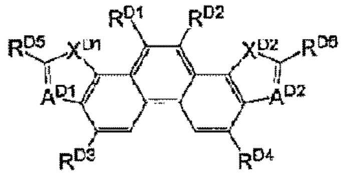

Formula (E)

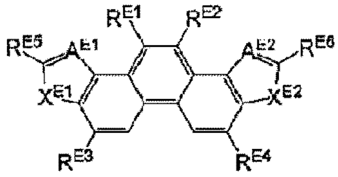

Formula (F)

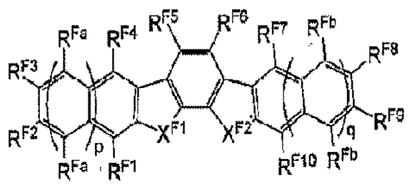

Formula (G)

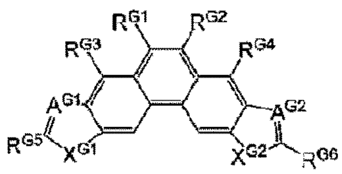

Formula (H)

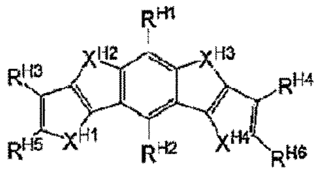

Formula (J)

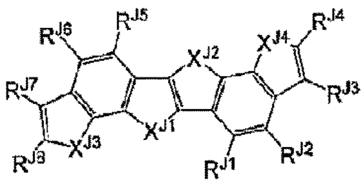

Formula (K)

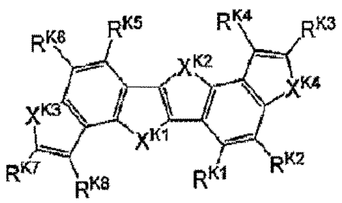

Formula (L)

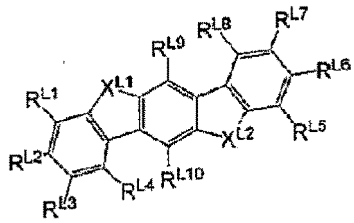

Formula (M)

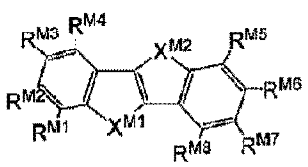

Formula (N)

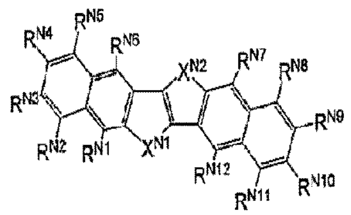

Formula (P)

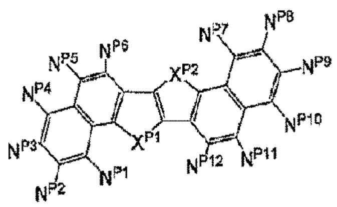

Formula (Q)

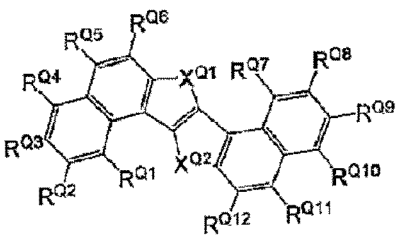

Formula (R)

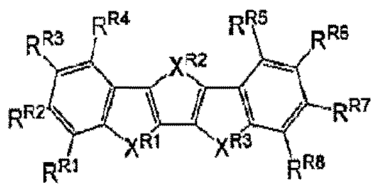

Formula (S)

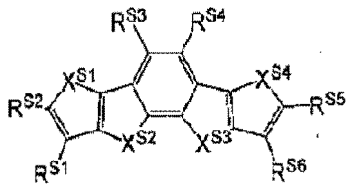

Formula (T)

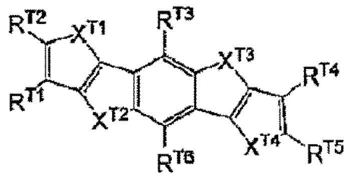

In Formula C, $A^{C1}$ and $A^{C2}$ represent an oxygen atom, a sulfur atom, or a selenium atom. $A^{C1}$ and $A^{C2}$ preferably both represent an oxygen atom or a sulfur atom, amd more preferably both represent a sulfur atom. $R^{C1}$ to $R^{C6}$ represents a hydrogen atom or a substituent. At least one of $R^{C1}$, $R^{C2}$, $R^{C3}$, $R^{C4}$, $R^{C5}$, or $R^{C6}$ is a substituent represented by the following Formula W.

In Formula D, $X^{D1}$ and $X^{D2}$ represent $NR^{D9}$, an oxygen atom, or a sulfur atom. $A^{D1}$ represents $CR^{D7}$ or a N atom, $A^{D2}$ represents $CR^{D8}$ or a N atom, or $R^{D9}$ represents a hydrogen atom, an alkyl group, an alkenyl group, an alkynyl group, or an acyl group. $R^{D1}$ to $R^{D8}$ represent a hydrogen atom or a substituent, and at least one of $R^{D1}$, $R^{D2}$, $R^{D3}$, $R^{D4}$, $R^{D5}$, $R^{D6}$, $R^{D7}$, or $R^{D8}$ is a substituent represented by the following Formula W.

In Formula E, $X^{E1}$ and $X^{E2}$ represent an oxygen atom, a sulfor atom, or $NR^{E7}$. $A^{E1}$ and $A^{E2}$ represent $CR^{E8}$ or a nitrogen atom. $R^{E1}$ to $R^{E8}$ represent a hydrogen atom or a substituent. At least one of $R^{E1}$, $R^{E2}$, $R^{E3}$, $R^{E4}$, $R^{E5}$, $R^{E6}$, $R^{E7}$, or $R^{E8}$ is a substituent represented by the following Formula W.

In Formula F, $X^{F1}$ and $X^{F2}$ represent an oxygen atom, a sulfur atom, or a selenium atom. $X^{F1}$ and $X^{F2}$ preferably represent an oxygen atom or a sulfur atom, and more preferably represents a sulfur atom. $R^{F1}$ to $R^{F10}$, $R^{Fa}$, and $R^{Fb}$ represent a hydrogen atom or a substituent. At least one of $R^{F1}$, $R^{F2}$, $R^{F3}$, $R^{F4}$, $R^{F5}$, $R^{F6}$, $R^{F7}$, $R^{F8}$, $R^{F9}$, $R^{F10}$, $R^{Fa}$, or $R^{Fb}$ is a substituent represented by Formula W. p and q represent an integer of 0 to 2.

In Formula G, $X^{G1}$ and $X^{G2}$ represent $NR^{G9}$, an oxygen atom, a sulfur atom. $A^{G2}$ represents $CR^{G8}$ or a N atom. $R^{G9}$ represents a hydrogen atom, an alkyl group, an alkenyl group, an alkynyl group, an acyl group, an aryl group, or a heteroaryl group. $R^{G1}$ to $R^{G8}$ represent a hydrogen atom or a substituent. At least one of $R^{G1}$, $R^{G2}$, $R^{G3}$, $R^{G4}$, $R^{G5}$, $R^{G6}$, $R^{G7}$, or $R^{G8}$ is a substituent represented by the following Formula W.

In Formula H, $X^{H1}$ to $X^{H4}$ represent $NR^{H7}$, an oxygen atom, or a sulfur atom. $X^{H1}$ to $X^{H4}$ preferably represent a sulfur atom. $R^{H7}$ represents an alkyl group, an alkenyl group, an alkynyl group, an acyl group, an aryl group, or a heteroaryl group. $R^{H1}$ to $R^{H6}$ represent a hydrogen atom or a substituent. At least one of $R^{H1}$, $R^{H2}$, $R^{H3}$, $R^{H4}$, $R^{H5}$, or $R^{H6}$ is a substituent represented by the following Formula W.

In Formula J, $X^{J1}$ and $X^{J2}$ represent an oxygen atom, a sulfur atom, a selenium atom, or $NR^{J9}$. $X^{J3}$ and $X^{J4}$ repersent an oxygen atom, a sulfur atom, or a selenium atom. $X^{J1}$, $X^{J2}$, $X^{J3}$, and $X^{J4}$ preferably represent a sulfur atom. $R^{J1}$ to $R^{J9}$ represent a hydrogen atom or a substituent. At least one of $R^{J1}$, $R^{J2}$, $R^{J3}$, $R^{J4}$, $R^{J5}$, $R^{J6}$, $R^{J7}$, $R^{J8}$, or $R^{J9}$ is a substituent represented by the following Formula W.

In Formula K, $X^{K1}$ and $X^{K2}$ represent an oxygen atom, a sulfur atom, a selenium atom, or $NR^{K9}$. $X^{K3}$ and $X^{K4}$ repersent an oxygen atom, a sulfur atom, or a selenium atom. $X^{K1}$, $X^{K2}$, $X^{K3}$, and $X^{K4}$ preferably represent a sulfur atom. $R^{K1}$ to $R^{K9}$ represent a hydrogen atom or a substituent. At least one of $R^{K1}$, $R^{K2}$, $R^{K3}$, $R^{K4}$, $R^{K5}$, $R^{K6}$, $R^{K7}$, $R^{K8}$, or $R^{K9}$ is a substituent represented by the following Formula W.

In Formula L, $X^{L1}$ and $X^{L2}$ represent an oxygen atom, a sulfur atom, or $NR^{L11}$. $X^{L1}$ and $X^{L2}$ preferably represent an oxygen atom or a sulfur atom. $R^{L1}$ to $R^{L11}$ represent a hydrogen atom or a substituent. At least one of $R^{L1}$, $R^{L2}$, $R^{L3}$, $R^{L4}$, $R^{L5}$, $R^{L6}$, $R^{L7}$, $R^{L8}$, $R^{L9}$, $R^{L10}$, or $R^{L11}$ is a substituent represented by the following Formula W.

In Formula M, $X^{M1}$ and $X^{M2}$ represent an oxygen atom, a sulfur atom, a selenium atom, or $NR^{M9}$. $X^{M1}$ and $X^{M2}$ preferably represent a sulfura atom. $R^{M1}$ to $R^{M9}$ represent a hydrogen atom or a substituent. At least one of $R^{M1}$, $R^{M2}$, $R^{M3}$, $R^{M4}$, $R^{M5}$, $R^{M6}$, $R^{M7}$, $R^{M8}$, or $R^{M9}$ is a substituent represented by the following Formula W.

In Formula N, $X^{N1}$ and $X^{N2}$ represent an oxygen atom, a sulfur atom, a selenium atom, or $NR^{N13}$. $X^{N1}$ and $X^{N2}$ preferably represent a sulfura atom. $R^{N1}$ to $R^{N13}$ represent a hydrogen atom or a substituent. At least one of $R^{N1}$, $R^{N2}$, $R^{N3}$, $R^{N4}$, $R^{N5}$, $R^{N6}$, $R^{N7}$, $R^{N8}$, $R^{N9}$, $R^{N10}$, $R^{N11}$, $R^{N12}$, or $R^{N13}$ is a substituent represented by the following Formula W.

In Formula P, $X^{P1}$ and $X^{P2}$ represent an oxygen atom, a sulfur atom, a selenium atom, or $NR^{P13}$. $X^{P1}$ and $X^{P2}$ preferably represent a sulfura atom. $R^{P1}$ to $R^{P13}$ represent a hydrogen atom or a substituent. At least one of $R^{P1}$, $R^{P2}$, $R^{P3}$, $R^{P4}$, $R^{P5}$, $R^{P6}$, $R^{P7}$, $R^{P8}$, $R^{P9}$, $R^{P10}$, $R^{P11}$, $R^{P12}$, or $R^{P13}$ is a substituent represented by the following Formula W.

In Formula Q, $X^{Q1}$ and $X^{Q2}$ represent an oxygen atom, a sulfur atom, a selenium atom, or $NR^{Q13}$. $X^{Q1}$ and $X^{Q2}$ preferably represent a sulfura atom. $R^{Q1}$ to $R^{Q13}$ represent a hydrogen atom or a substituent. At least one of $R^{Q1}$, $R^{Q2}$, $R^{Q3}$, $R^{Q4}$, $R^{Q5}$, $R^{Q6}$, $R^{Q7}$, $R^{Q8}$, $R^{Q9}$, $R^{Q10}$, $R^{Q11}$, $R^{Q12}$, or $R^{Q13}$ is a substituent represented by the following Formula W.

In Formula R, $X^{R1}$, $X^{R2}$, and $X^{R3}$ represent an oxygen atom, a sulfur atom, a selenium atom, or $NR^{R9}$. $X^{R1}$, $X^{R2}$, and $X^{R3}$ preferably represent a sulfura atom. $R^{R1}$ to $R^{R9}$ represent a hydrogen atom or a substituent. At least one of $R^{R1}$, $R^{R2}$, $R^{R3}$, $R^{R4}$, $R^{R5}$, $R^{R6}$, $R^{R7}$, $R^{R8}$, or $R^{R9}$ is a substituent represented by the following Formula W.

In Formula S, $X^{S1}$, $X^{S2}$, $X^{S3}$, and $X^{S4}$ represent an oxygen atom, a sulfur atom, a selenium atom, or $NR^{S7}$. $X^{S1}$, $X^{S2}$, $X^{S3}$, and $X^{S4}$ preferably represent a sulfur atom. $R^{S1}$ to $R^{S7}$ represent a hydrogen atom or a substituent. At least one of $R^{S1}$, $R^{S2}$, $R^{S3}$, $R^{S4}$, $R^{S5}$, $R^{S6}$, or $R^{S7}$ is a substituent represented by the following Formula W.

In Formula T, $X^{T1}$, $X^{T2}$, $X^{T3}$, and $X^{T4}$ represent an oxygen atom, a sulfur atom, a selenium atom, or $NR^{T7}$. $X^{T1}$, $X^{T2}$, $X^{T3}$, and $X^{T4}$ preferably represent a sulfur atom. $R^{T11}$ to $R^{T7}$ represent a hydrogen atom or a substituent. At least one of $R^{T1}$, $R^{T2}$, $R^{T3}$, $R^{T4}$, $R^{T5}$, $R^{T6}$, or $R^{T7}$ is a substituent represented by the following Formula W.

Hereinafter, $R^{C1}$ to $R^{C6}$, $R^{D1}$ to $R^{D8}$, $R^{E1}$ to $R^{E8}$, $R^{F1}$ to $R^{F10}$, $R^{Fa}$ and $R^{Fb}$, $R^{G1}$ to $R^{G8}$, $R^{H1}$ to $R^{H6}$, $R^{J1}$ to $R^{J9}$, $R^{K1}$ to $R^{K9}$, $R^{L1}$ to $R^{L11}$, $R^{M1}$ to $R^{M9}$, $R^{N1}$ to $R^{N13}$, $R^{P1}$ to $R^{P13}$, $R^{Q1}$ to $R^{Q13}$, $R^{R1}$ to $R^{R9}$, $R^{S1}$ to $R^{S7}$, and $R^{T1}$ to $R^{T7}$ (hereinafter, substituents $R^C$ to $R^T$ as well) representing a hydrogen atom or a substituent in each of the above formulae will be described.

Examples of substituents that the substituents $R^C$ to $R^T$ can adopt include a halogen atom, an alkyl group (an alkyl group having 1 to 40 carbon atoms such as methyl, ethyl, propyl, butyl, pentyl, hexyl, heptyl, octyl, nonyl, decyl, undecyl, dodecyl, tridecyl, tetradecyl, or pentadecyl; here, the alkyl group includes 2,6-dimethyloctyl, 2-decyltetradecyl, 2-hexyldecyl, 2-ethyloctyl, 2-butyldecyl, 1-octylnonyl, 2-octyltetradecyl, 2-ethylhexyl, cycloalkyl, bicycloalkyl, tricycloalkyl, and the like), an alkenyl group (including 1-pentenyl, cycloalkenyl, bicycloalkenyl, and the like), an alkynyl group (including 1-pentenyl, trimethylsilylethynyl, triethylsilylethynyl, tri-i-propylsilylethynyl, 2-p-propylphenylethynyl, and the like), an aryl group (including an aryl group having 6 to 20 carbon atoms such as phenyl, naphthyl, p-pentylphenyl, 3,4-dipentylphenyl, p-heptoxyphenyl, or 3,4-diheptoxyphenyl, and the like), a heterocyclic group (may be referred to as a hetero ring group, including 2-hexylfuranyl and the like), a cyano group, a hydroxy group, a nitro group, an acyl group (including hexanonyl, benzoyl, and the like), an alkoxy group (including butoxy and the like), an aryloxy group, a silyloxy group, a heterocyclic oxy group, an acyloxy group, a carbamoyloxy group, an amino group (including anilino), an acylamino group, an aminocarbonylamino group (including a ureido group), an alkoxy- and aryloxycarbonylamino group, an alkyl- and arylsulfonylamino group, a mercapto group, an alkyl- and arylthio group (including methylthio, octylthio, and the like), a heterocyclic thio group, a sulfamoyl group, a sulfo group, an alkyl- and arylsulfinyl group, an alkyl- and arylsulfonyl group, an alkyl- and aryloxycarbonyl group, a carbamoyl group, an aryl- and heterocyclic azo group, an imido group, a phoshino group, a phosphinyl group, a phosphinyloxy group, a phosphinylamino group, a phosphono group, a silyl group (such as a ditrimethylsiloxymethyl butoxy group), a hydrazino group, a ureido group, a boronic acid group ($-B(OH)_2$), a phosphato group ($-OPO(OH)_2$), a sulfato group ($-OSO_3H$), and other known substituents.

These substituents may further have the substituents described above.

Among these, the substituents that the substituents $R^C$ to $R^T$ can adopt, an alkyl group, an aryl group, an alkenyl group, an alkynyl group, a heterocyclic group, an alkoxy group, an alkylthio group, and a group represented by Formula W which will be described later are preferable, an alkyl group having 1 to 12 carbon atoms, an aryl group having 6 to 20 carbon atoms, an alkenyl group having 2 to 12 carbon atoms, an alkynyl group having 2 to 12 carbon atoms, an alkoxy group having 1 to 11 carbon atoms, a heterocyclic group having 5 to 12 carbon atoms, an alkylthio group having 1 to 12 carbon atoms, and a group represented by Formula W which will be described later are more preferable, and a group represented by Formula W which will be described later is particularly preferable.

The alkyl group, the alkenyl group, the alkynyl group, the acyl group, and the aryl group as $R^{D9}$, $R^{G9}$, and $R^{H7}$ described above each have the same definition as the alkyl group, the alkenyl group, the alkynyl group, the acyl group, and the aryl group described as the substituents that the substituents $R^C$ to $R^T$ can adopt.

The heteroaryl group has the same definition as the heteroaryl group described as the substituent of $R^{A1}$ to $R^{A6}$.

The group represented by Formula W: $-L-R^W$ will be described.

In Formula W, L represents a divalent linking group represented by any one of the following Formulae L-1 to L-25 or a divalent linking group in which two or more divalent linking groups represented by any one of the following Formulae L-1 to L-25 are bonded to each other. $R^W$ represents a substituted or unsubstituted alkyl group, a cyano group, a vinyl group, an ethynyl group, an oxyethylene group, an oligo-oxyethylene group in which a repetition number v of an oxyethylene unit is equal to or greater than 2, a siloxane group, an oligosiloxane group having two or more silicon atoms, or a substituted or unsubstituted trialkylsilyl group.

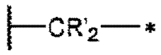 (L-1)

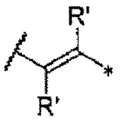 (L-2)

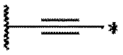 (L-3)

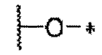 (L-4)

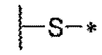 (L-5)

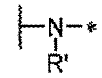 (L-6)

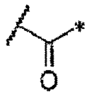 (L-7)

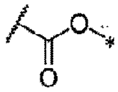 (L-8)

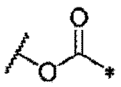 (L-9)

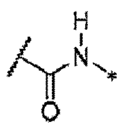 (L-10)

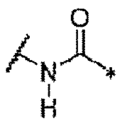 (L-11)

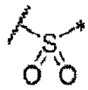 (L-12)

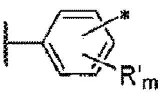 (L-13)

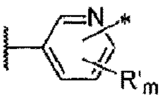 (L-14)

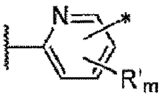 (L-15)

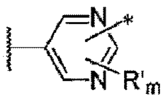 (L-16)

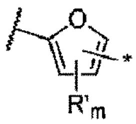 (L-17)

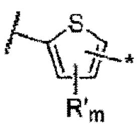 (L-18)

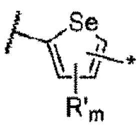 (L-19)

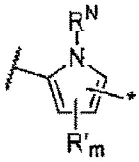 (L-20)

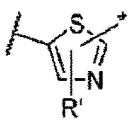 (L-21)

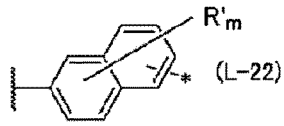 (L-22)

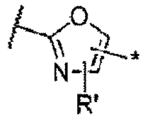 (L-23)

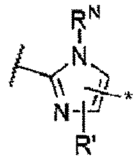 (L-24)

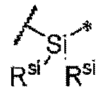 (L-25)

In Formulae L-1 to L-25, the portion of a wavy line represents a position in which the linking group is bonded to any one of the rings forming each skeleton represented by Formulae C to H, J to N, and P to T described above. In the present specification, in a case where L represents a divalent linking group in which two or more divalent linking groups represented by any one of Formulae L-1 to L-25 are bonded to each other, the portion of a wavy line may represent a position in which the linking group is bonded to any one of the rings forming each skeleton represented by Formulae C to H, J to N, and P to T described above and a position in which the linking group is bonded to any one of the divalent linking groups represented by Formulae L-1 to L-25.

**[0098]** * represents a position in which the linking group is bonded to $R^W$.

m in Formula L-13 represents 4, m in Formulae L-14 and L-15 represents 3, and m in Formulae L-16 to L-20 represents 2, and m in Formula L-22 represents 6.

R' in Formulae L-1, L-2, L-6, L-13 to L-19, and L-21 to L-24 each independently represents a hydrogen atom or a substituent, and R' in Formulae L-1 and L-2 may each form a fused ring by being bonded to $R^W$ adjacent to L.

$R^N$ represents a hydrogen atom or a substituent, $R^{si}$ each independently represents a hydrogen atom, an alkyl group, an alkenyl group, or an alkynyl group.

The divalent linking group represented by Formulae L-17 to L-21, L-23, and L-24 is more preferably a divalent linking group represented by the following Formulae L-17A to L-21A, L-23A, and L-24A.

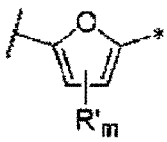
(L-17A)

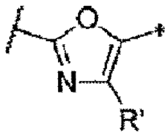
(L-23A)

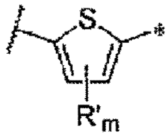
(L-18A)

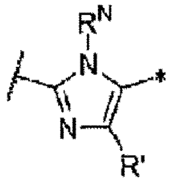
(L-24A)

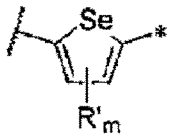
(L-19A)

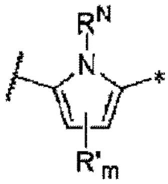
(L-20A)

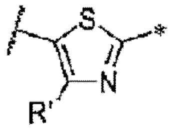
(L-21A)

In a case where a substituted or unsubstituted alkyl group, an oxyethylene group, an oligo-oxyethylene group in which a repetition number v of an oxyethylene unit is equal to or greater than 2, a siloxane group, an oligosiloxane group having two or more silicon atoms, or a substituted or unsubstituted trialkylsilyl group is present on the terminal of a substituent, the substituent can be interpreted as a substituent consisting only of -$R^W$ in Formula W or a substituent consisting of -L-$R^W$ in Formula W.

In the present invention, in a case where a substituted or unsubstituted alkyl group having a main chain consisting of N carbon atoms is present on the terminal of a substituent, the substituent is interpreted as -L-$R^W$ in Formula W including as many linking groups as possible from the terminal of the substituent and is not interpreted as a substituent consisting only of -$R^W$ in Formula W. Specifically, the substituent is interpreted as a substituent in which "one group represented by Formula L-1 corresponding to $L^W$ in Formula W" and "a substituted or unsubstituted alkyl group which corresponds to $R^W$ in Formula W and has a main chain consisting of (N - 1) carbon atoms" are bonded to each other. For example, in a case where a n-octyl group which is an alkyl group having eight carbon atoms is present on the terminal of a substituent, the substituent is interpreted as a substituent in which one group represented by Formula L-1, in which two R's represent hydrogen atoms, and a n-pentyl group having 7 carbon atoms are bonded to each other. Furthermore, in a case where the substituent represented by Formula W is an alkoxy group having eight carbon atoms, the substituent is interpreted as a substituent in which one linking group represented by Formula L-4 as -O-, one linking group represented by Formula L-1 in which two R's represent hydrogen atoms, and a n-heptyl group having seven carbon atoms are bonded to each other.

In contrast, in the present invention, in a case where an oxyethylene group, an oligo-oxyethylene group in which a repetition number v of an oxyethylene unit is equal to or greater than 2, a siloxane group, an oligosiloxane group having two or more silicon atoms, or a substituted or unsubstituted trialkylsilyl group is present on the terminal of a substituent, the substituent is interpreted as a substituent consisting only of $R^W$ in Formula W including as many linking groups as possible from the terminal of the substituent. For example, in a case where a $-(OCH_2CH_2)-(OCH_2CH_2)-(OCH_2CH_2)-OCH_3$ group is present on the terminal of a substituent, the substituent is interpreted as a substituent consisting only of an oligo-oxyethylene group in which a repetition number v of an oxyethylene unit is 3.

In a case where L forms a linking group in which divalent linking groups represented by any one of Formulae L-1 to L-25 are bonded to each other, the number of bonded divalent linking groups represented by any one of Formulae L-1 to L-25 is preferably 2 to 4, and more preferably 2 or 3.

Examples of the substituent R' in Formulae L-1, L-2, L-6, and L-13 to L-24 include those exemplified as substituents that the substituents $R^C$ to $R^T$ of Formulae C to H, J to N, and P to T can adopt. The substituent R' in Formula L-6 among the above formulae is preferably an alkyl group. In a case where R' in Formula L-6 is an alkyl group, the number of carbon atoms of the alkyl group is preferably 1 to 9, more preferably 4 to 9 from the viewpoint of chemical stability and cariier transport properites, and even more preferably 5 to 9. In a case where R' in Formula L-6 is an alkyl group, the alkyl group is preferably a linear alkyl group, because then carrier mobility can be improved.

Examples of $R^N$ include those exemplified as substituents that the substituents $R^C$ to $R^T$ can adopt. $R^N$ is preferably a hydrogen atom or a methyl group among the substituents.

$R^{si}$ is preferably an alkyl group. The alkyl group that $R^{si}$ can adopt is not particularly limited. A preferred range of the alkyl group that that $R^{si}$ can adopt is the same as a preferred range of an alkyl group that a silyl group can adopt in a case where $R^W$ represents the silyl group. The alkenyl group that $R^{si}$ can adopt is not particularly limited. The alkenyl group is preferably a substituted or unsubstituted alkenyl group and more preferably a branched alkenyl group, and the alkenyl group preferably has 2 or 3 carbon atoms. The alkynyl group that $R^{si}$ can adopt is not particularly limited. The alkynyl group is preferably a substituted or unsubstituted alkynyl group and more preferably a branched alkynyl group, and the alkynyl group preferably has 2 or 3 carbon atoms.

L is preferably a divalent linking group which is represented by any one of Formulae L-1 to L-5, L-13, L-17, and L-18 or a divalent linking group in which two or more divalent linking groups represented by any one of Formulae L-1 to L-5, L-13, L-17, and L-18 are bonded to each other, more preferably a divalent linking group which is represented by any one of Formulae L-1, L-3, L-13, and L-18 or a divalent linking group in which two or more divalent linking groups represented by any one of Formulae L-1, L-3, L-13, and L-18 are bonded to each other, and particularly preferably a divalent linking group which is represented by any one of Formulae L-1, L-3, L-13, and L-18 or a divalent linking group in which a divalent linking group represented by any one of Formulae L-3, L-13, and L-18 and a divalent linking group represented by Formula L-1 are bonded to each other. It is preferable that, in the divalent linking group, in which a divalent linking group represented by any one of Formulae L-3, L-13, and L-18 and a divalent linking group represented by Formula L-1 are bonded to each other, the divalent linking group represented by Formula L-1 is bonded to the $R^W$ side.

From the viewpoint of chemical stability and carrier transport properties, L is particularly preferably a divalent linking group containing a divalent linking group represented by Formula L-1, and more particularly preferably a divalent linking group represented by Formula L-1. It is more particularly preferable that L is a divalent linking group represented by Formulae L-18 and L-1 and bonded to $R^W$ through L-1, and $R^W$ is a substituted or unsubstituted alkyl group. It is even more particularly preferable that L is a divalent linking group represented by Formulae L-18A and L-1 and bonded to $R^W$ through L-1, and $R^W$ is a substituted or unsubstituted alkyl group.

In Formula W, $R^W$ is preferably a substituted or unsubstituted alkyl group. In Formula W, in a case where L adjacent to $R^W$ is a divalent linking group which is represented by Formula L-1, $R^W$ is preferably a substituted or unsubstituted alkyl group, an oxyethylene group, an oligo-oxyethylene group in which a repetition number v of an oxyethylene unit is equal to or greater than 2, a siloxane group, or an oligosiloxane group having two or more silicon atoms, and more preferably a substituted or unsubstituted alkyl group.

In Formula W, in a case where L adjacent to $R^W$ is a divalent linking group which is represented by any one of Formula L-2 and Formulae L-4 to L-25, $R^W$ is more preferably a substituted or unsubstituted alkyl group.

In Formula W, in a case where L adjacent to $R^W$ is a divalent linking group which is represented by Formula L-3, $R^W$ is preferably a substituted or unsubstituted alkyl group or a substituted or unsubstituted silyl group.

In a case where $R^W$ is a substituted or unsubstituted alkyl group, the number of carbon atoms thereof is preferably 4 to 17, more preferably 6 to 14 from the viewpoint of chemical stability and carrier transport properties, and even more preferably 6 to 12. It is preferable that R is a long-chain alkyl group having carbon atoms within the above range, particularly, a long-chain linear alkyl group, because then the linearity of the molecule is improved, and hence the carrier mobility can be improved.

In a case where $R^W$ represents an alkyl group, the alkyl group may be linear, branched, or cyclic. It is preferable that the alkyl group is a linear alkyl group, because then the linearity of the molecule is improved, and hence the carrier mobility can be improved.

Particularly, from the viewpoint of improving the carrier mobility, $R^W$ and $L^W$ in Formula W preferably form a combination in which L in Formulae C to H, J to N, and P to T is a divalent linking group represented by Formula L-1 and $R^W$ is a linear alkyl group having 4 to 17 carbon atoms or a combination in which L is a divalent linking group, in which a divalent linking group represented by any one of Formulae L-3, L-13, and L-18 and a divalent linking group represented by Formula L-1 are bonded to each other, and $R^W$ is a linear alkyl group.

In a case where L is a divalent linking group represented by Formula L-1 and $R^W$ is a linear alkyl group having 4 to 17 carbon atoms, $R^W$ is more preferably a linear alkyl group having 6 to 14 carbon atoms from the viewpoint of

improving the carrier mobility, and particularly preferably a linear alkyl group having 6 to 12 carbon atoms.

In a case where L is a divalent linking group, in which a divalent linking group represented by any one of Formulae L-3, L-13, and L-18 and a divalent linking group represented by Formula L-1 are bonded to each other, and $R^W$ is a linear alkyl group, $R^W$ is more preferably a linear alkyl group having 4 to 17 carbon atoms, even more preferably a linear alkyl group having 6 to 14 carbon atoms from the viewpoint of chemical stability and carrier transport properties, and particularly preferably a linear alkyl group having 6 to 12 carbon atoms from the viewpoint of improving the carrier mobility.

In contrast, from the viewpoint of improving the solubility of the compound in an organic solvent, $R^W$ is preferably a branched alkyl group.

In a case where $R^W$ is an alkyl group having a substituent, examples of the substituent include a halogen atom and the like, and the halogen atom is preferably a fluorine atom. In a case where $R^W$ is an alkyl group having a fluorine atom, all of the hydrogen atoms of the alkyl group may be substituted with fluorine atoms such that a perfluoroalkyl group is formed. Here, $R^W$ is preferably an unsubstituted alkyl group.

In the present specification, in a case where $R^W$ is an ethyleneoxy group or an oligoethyleneoxy group, the "oligo-oxyethylene group" represented by $R^W$ refers to a group represented by $-(OCH_2CH_2)_vOY$ (the repetition number v of an oxyethylene unit represents an integer of equal to or greater than 2, and Y on the terminal represents a hydrogen atom or a substituent). In a case where Y on the terminal of the oligo-oxyethylene group is a hydrogen atom, the terminal becomes a hydroxy group. The repetition number v of the oxyethylene unit is preferably 2 to 4, and more preferably 2 or 3. It is preferable that the hydroxy group on the terminal of the oligo-oxyethylene group is sealed. That is, it is preferable that Y represents a substituent. In this case, the hydroxy group is preferably sealed with an alkyl group having 1 to 3 carbon atoms. That is, Y is preferably an alkyl group having 1 to 3 carbon atoms, more preferably a methyl group or an ethyl group, and particularly preferably a methyl group.

In a case where $R^W$ is a siloxane group or an oligosiloxane group, a repetition number of the siloxane unit is preferably 2 to 4, and more preferably 2 or 3. Furthermore, it is preferable that a hydrogen atom or an alkyl group is bonded to each Si atom). In a case where an alkyl group is bonded to the Si atom, the number of carbon atoms of the alkyl group is preferably 1 to 3. For example, it is preferable that a methyl group or an ethyl group is bonded to the Si atom. The same alkyl groups may be bonded to the Si atoms, or different alkyl groups or hydrogen atoms may be bonded to the Si atoms. All of the siloxane units constituting the oligosiloxane group may be the same as or different from each other, but it is preferable that all of them are the same as each other.

In a case where L adjacent to $R^W$ is a divalent linking group represented by Formula L-3, $R^W$ is a substituted or unsubstituted trialkylsilyl group. In a case where $R^W$ is a substituted or unsubstituted silyl group. In a case where $R^W$ is a substituted or unsubstituted silyl group, $R^W$ is particularly preferably a substituted silyl group. The substituent of the silyl group is not particularly limited, but the substituent is preferably a substituted or unsubstituted alkyl group and more preferably a branched alkyl group. In a case where $R^W$ is a trialkylsilyl group, the number of carbon atoms of the alkyl group bonded to each Si atom is preferably 1 to 3. For example, it is preferable that a methyl group, an ethyl group, or an isopropyl group is bonded to the Si atoms. The same alkyl groups or different alkyl groups may be bonded to the Si atom. In a case where $R^W$ is a trialkylsilyl group further having a substituent on an alkyl group, the substituent is not particularly limited.

In Formula W, the total number of carbon atoms contained in L and $R^W$ is preferably 5 to 18. If the total number of carbon atoms contained in L and $R^W$ is equal to or greater than the lower limit of the above range, the carrier mobility is improved, and the driving voltage is reduced. If the total number of carbon atoms contained in L and $R^W$ is equal to or less than the upper limit of the above range, the solubility of the compound in an organic solvent is improved.

The total number of carbon atoms contained in L and $R^W$ is preferably 5 to 14, more preferably 6 to 14, even more preferably 6 to 12, and particularly preferably 8 to 12.

In each of the compounds represented by Formulae C to H, J to N, and P to T, the number of groups represented by Formula W among the substituents $R^C$ to $R^T$ is preferably 1 to 4, because then the carrier mobility and the solubility of the compound in an organic solvent are improved, more preferably 1 or 2, and particularly preferably 2.

The position of the group represented by Formula W among the substituents $R^C$ to $R^T$ is not particularly limited.

In the compound represented by Formula C, it is preferable that any one of $R^{C1}$, $R^{C2}$, $R^{C3}$, and $R^{C6}$ is the group represented by Formula W. It is more preferable that both of $R^{C1}$ and $R^{C2}$ or both of $R^{C3}$ and $R^{C6}$ are the group represented by Formula W.

In the compound represented by Formula D, it is preferable that $R^{D6}$ is the group represented by Formula W. It is more preferable that both of $R^{D5}$ and $R^{D6}$ are the group represented by Formula W.

In the compound represented by Formula E, it is preferable that $R^{E6}$ is the group represented by Formula W. It is more preferable that both of $R^{E5}$ and $R^{E6}$ are the group represented by Formula W. In a case where RE5 and RE6 are a substituent other than the group represented by Formula W, two $R^{E7}$'s are preferably the group represented by Formula W.

In the compound represented by Formula F, at least any one of $R^{F2}$, $R^{F3}$, $R^{F8}$, or $R^{F9}$ is preferably the substituent

represented by Formula W.

In the compound represented by Formula G, $R^{G5}$ and $R^{G6}$ are preferably the group represented by Formula W, because then the carrier mobility is improved, and the solubility of the compound in an organic solvent is improved.

In the compound represented by Formula H, it is preferable that $R^{H4}$ and $R^{H6}$ are the group represented by Formula W. It is more preferable that $R^{H4}$ or $R^{H6}$ and $R^{H3}$ or $R^{H5}$ are preferably the group represented by Formula W.

In the compound represented by Formula J, it is preferable that $R^{J8}$ is the group represented by Formula W. It is more preferable that both of $R^{J8}$ and $R^{J4}$ are the group represented by Formula W.

In the compound represented by Formula K, it is preferable that $R^{K7}$ is the group represented by Formula W. It is more preferable that both of $R^{K7}$ and $R^{K3}$ are the group represented by Formula W.

In the compound represented by Formula L, at least one of $R^{L2}$, $R^{L3}$, $R^{L6}$, or $R^{L7}$ is more preferably the group represented by Formula W.

In the compound represented by Formula M, it is preferable that $R^{M2}$ is the group represented by Formula W. It is more preferable that both of $R^{M2}$ and $R^{M6}$ are the group represented by Formula W.

In the compound represented by Formula N, it is preferable that $R^{N3}$ is the group represented by Formula W. It is more preferable that both of $R^{N3}$ and $R^{N9}$ are the group represented by Formula W.

In the compound represented by Formula P, it is preferable that $R^{P3}$ is the group represented by Formula W. It is more preferable that both of $R^{P3}$ and $R^{P9}$ are the group represented by Formula W.

In the compound represented by Formula Q, it is preferable that $R^{Q3}$ is the group represented by Formula W. It is more preferable that both of $R^{Q3}$ and $R^{Q9}$ are the group represented by Formula W.

In the compound represented by Formula R, it is preferable that $R^{R2}$ is the group represented by Formula W. It is more preferable that both of $R^{R2}$ and $R^{R7}$ are the group represented by Formula W.

In the compound represented by Formula S, it is preferable that $R^{S2}$ is the group represented by Formula W. It is more preferable that both of $R^{S2}$ and $R^{S5}$ are the group represented by Formula W.

In the compound represented by Formula T, it is preferable that $R^{T2}$ is the group represented by Formula W. It is more preferable that both of $R^{T2}$ and $R^{T5}$ are the group represented by Formula W.

Among the substituents $R^C$ to $R^T$, the number of substituents other than the group represented by Formula W is preferably 0 to 4, and more preferably 0 to 2.

Specific examples of each of the compounds represented by Formulae C to H, J to N, and P to T will be shown below, but the compound that can be used in the present invention is not limited to the specific examples.

Specific examples of the compound C represented by Formula C will be shown below.

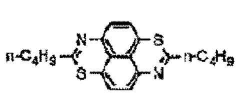

Compound C1

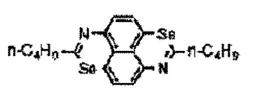

Compound C2

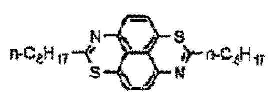

Compound C3

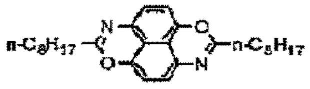

Compound C4

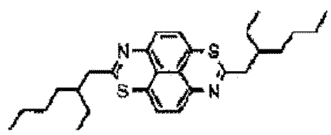

Compound C5

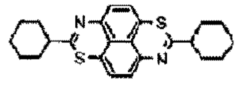

Compound C6

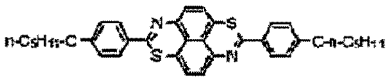

Compound C7

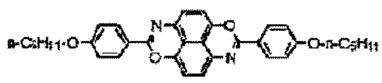

Compound C8

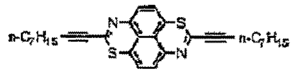

Compound C9

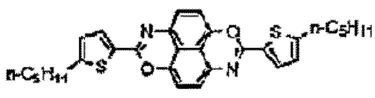

Compound C10

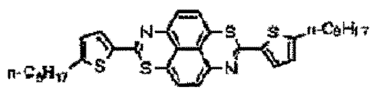

Compound C11

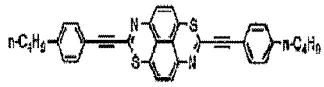

Compound C12

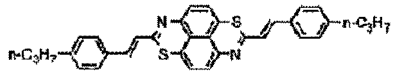

Compound C13

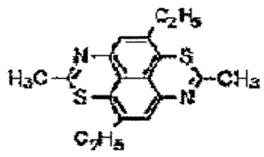

Compound C14

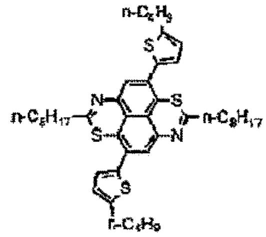

Compound C15

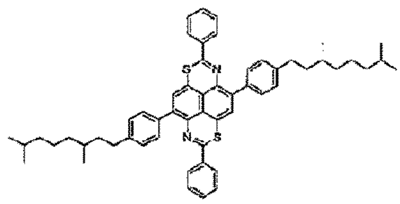

Compound C16

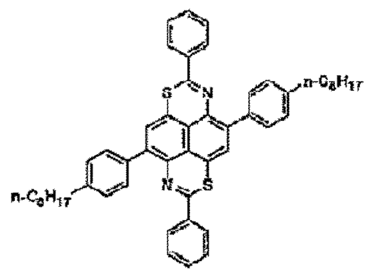

Compound C17

The molecular weight of the compound represented by Formula C is preferably equal to or less than 3,000, more preferably equal to or less than 2,000, even more preferably equal to or less than 1,000, and particularly preferably equal to or less than 850. If the molecular weight is within the above range, the solubility of the compound in a solvent can be improved.

In contrast, from the viewpoint of the film quality stability of a thin film, the molecular weight is preferably equal to or greater than 300, more preferably equal to or greater than 350, and even more preferably equal to or greater than 400.

Specific examples of the compound D represented by Formula D will be shown below.

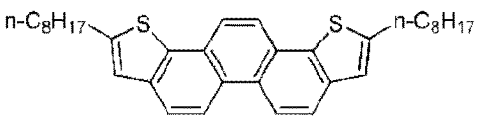

Compound D1

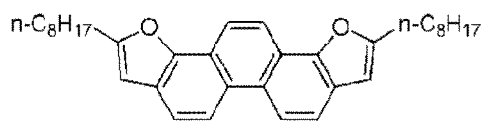

Compound D2

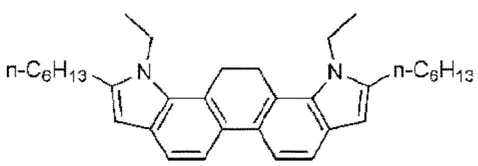

Compound D3

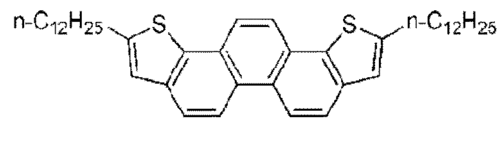

Compound D4

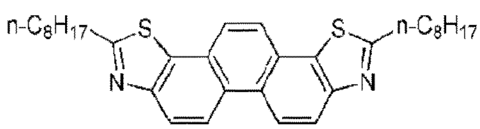

Compound D5

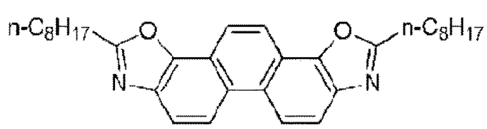

Compound D6

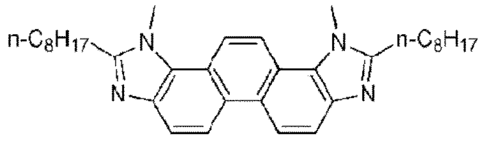

Compound D7

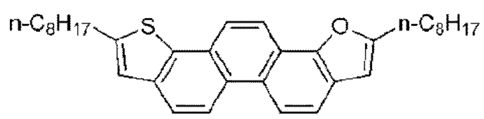

Compound D8

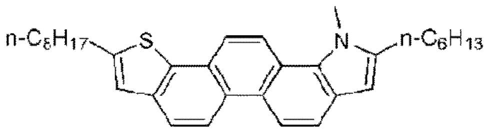

Compound D9

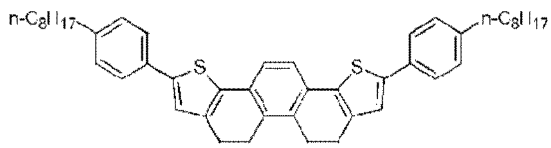

Compound D10

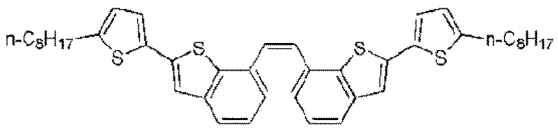

Compound D11

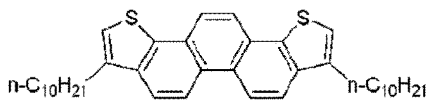

Compound D12

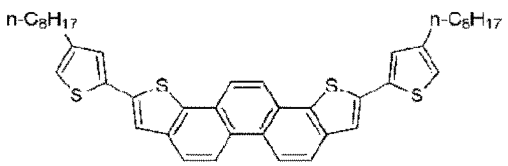

Compound D13

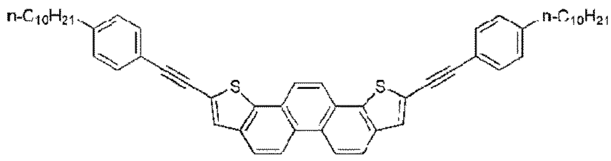

Compound D14

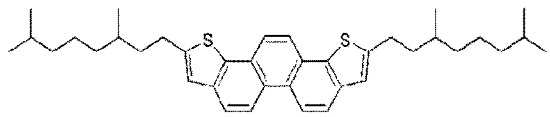

Compound D15

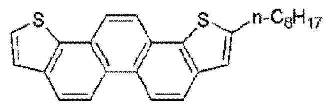

Compound D16

It is preferable that the upper limit of the molecular weight of the compound represented by Formula D is the same as that of the compound represented by Formula C, because then the solubility of the compound in a solvent can be improved. In contrast, from the viewpoint the film quality stability of a thin film, the molecular weight is preferably equal to or greater than 400, more preferably equal to or greater than 450, and even more preferably equal to or greater than 500.

Specific examples of each of the compound E represented by Formula E, the compound F represented by Formula F, the compound G represented by Formula G, and the compound H represented by Formula H will be sequentially shown below.

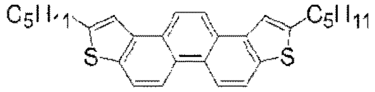

Compound E1

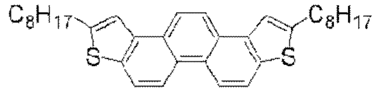

Compound E2

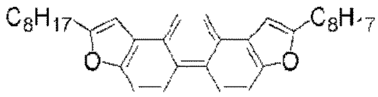

Compound E3

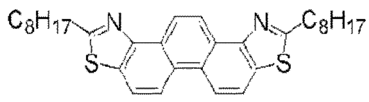

Compound E4

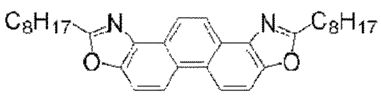

Compound E5

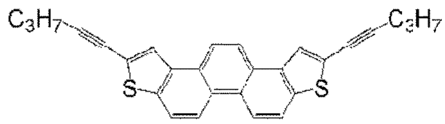

Compound E6

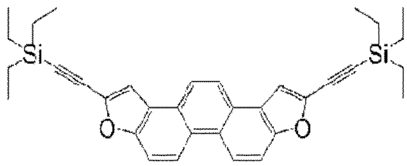

Compound E7

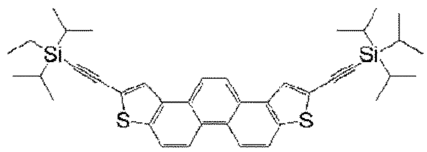

Compound E8

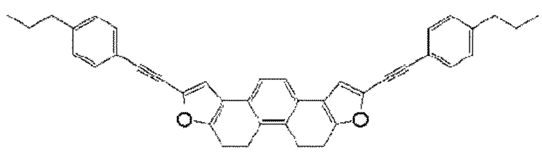

Compound E9

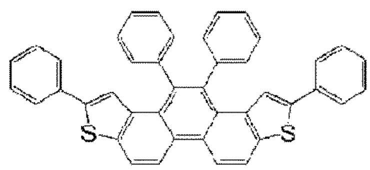

Compound E10

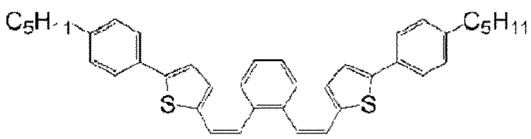

Compound E11

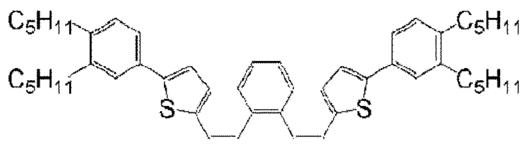

Compound E12

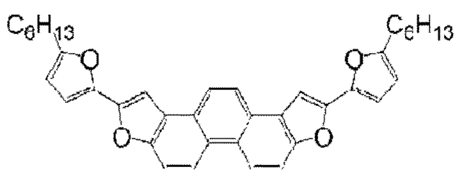

Compound E13

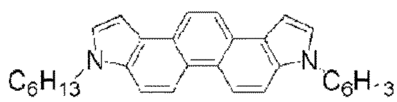

Compound E14

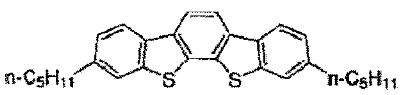

Compound F1

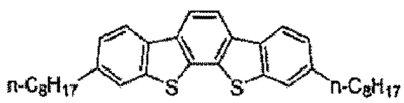

Compound F2

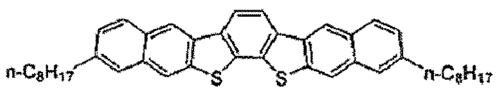

Compound F3

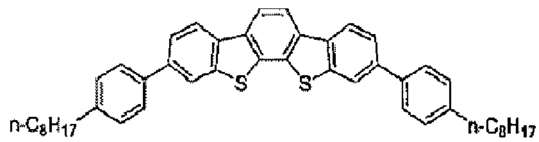

Compound F4

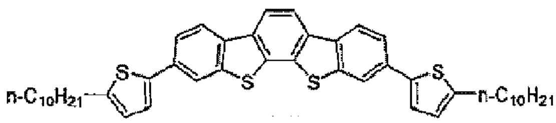

Compound F5

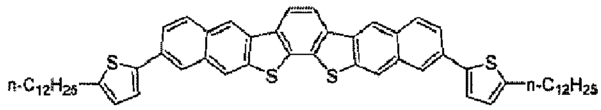

Compound F6

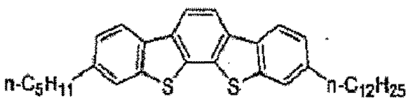

Compound F7

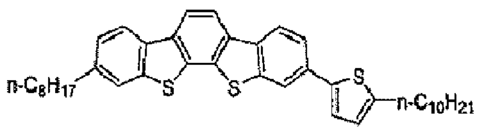

Compound F8

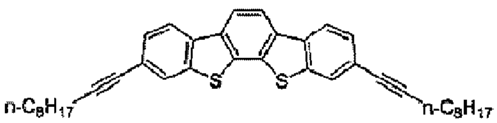

Compound F9

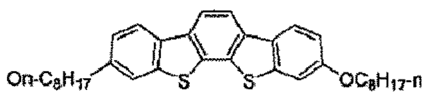

Compound F10

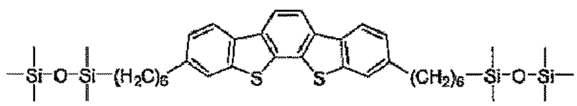

Compound F11

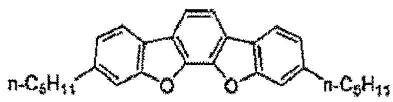

Compound F12

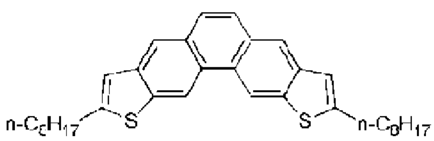

Compound G1

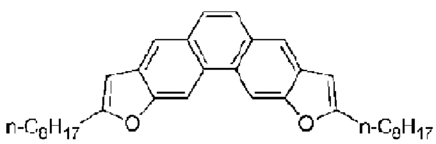

Compound G2

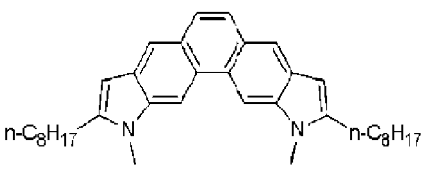

Compound G3

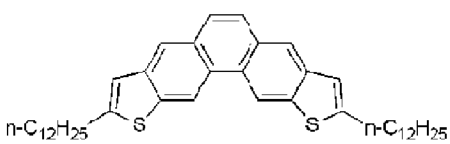

Compound G4

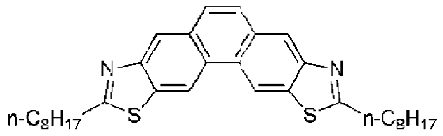

Compound G5

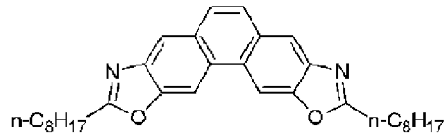

Compound G6

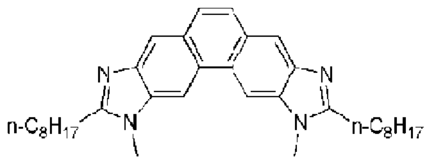

Compound G7

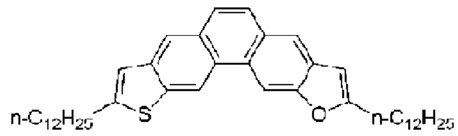

Compound G8

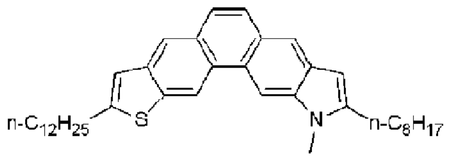

Compound G9

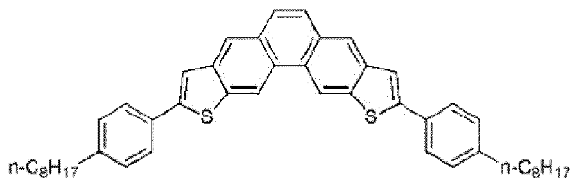

Compound G10

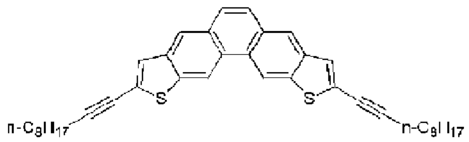

Compound G11

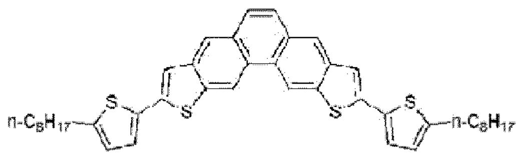

Compound G12

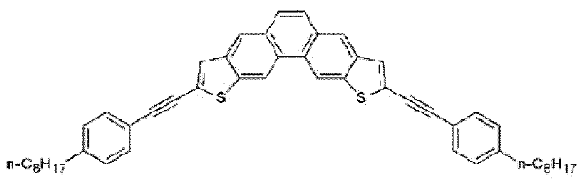

Compound G13

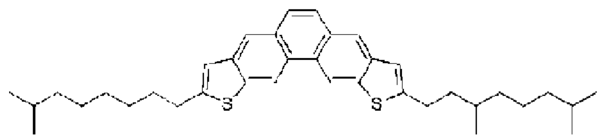

Compound G14

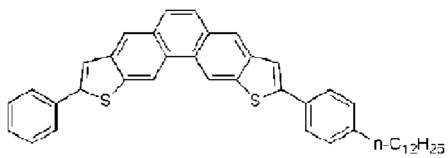

Compound G15

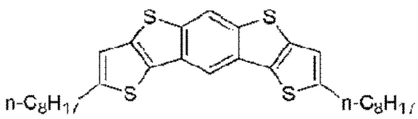

Compound H1

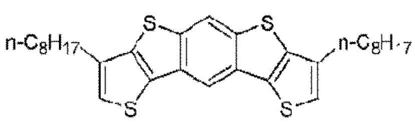

Compound H2

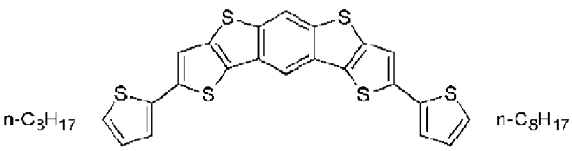

Compound H3

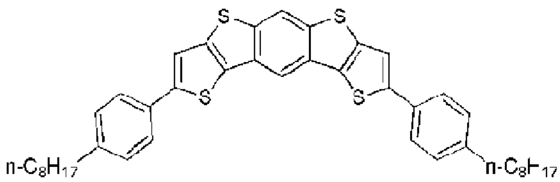

Compound H4

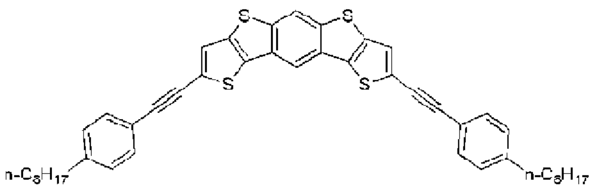

Compound H5

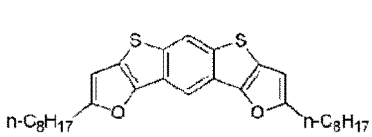

Compound H6

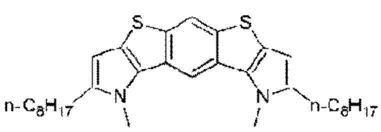

Compound H7

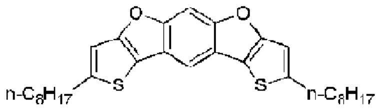

Compound H8

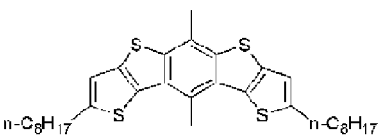

Compound H9

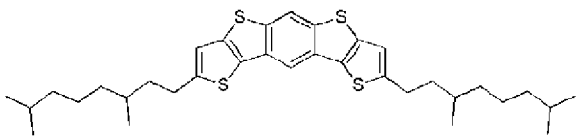

Compound H10

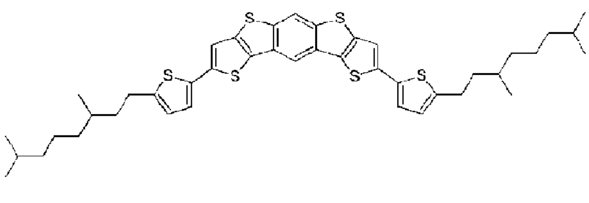

Compound H11

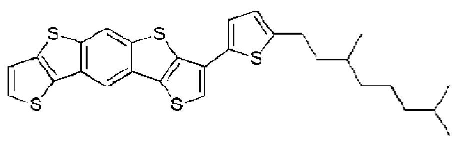

Compound H12

It is preferable that the upper limit of the molecular weight of each of the compound E, the compound F, the compound G, and the compound H is the same as that of the compound C represented by Formula C, because then the solubility of the compound in a solvent can be improved. In contrast, from the viewpoint of the film quality stability of a thin film, the lower limit of the molecular weight is the same as that of the compound represented by Formula D.

Specific examples of the compound J and the compound K represented by Formulae J and K will be shown below.

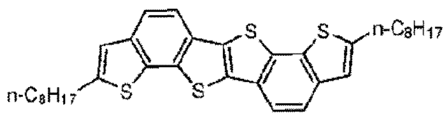

Compound J1

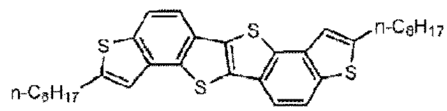

Compound K1

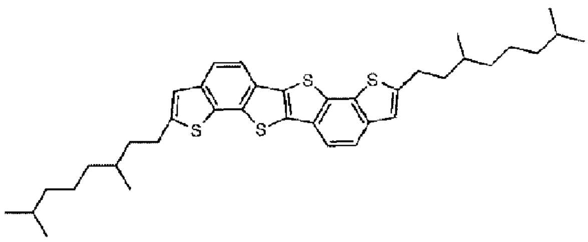

Compound J2

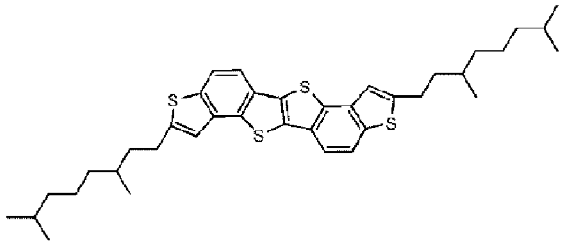

Compound K2

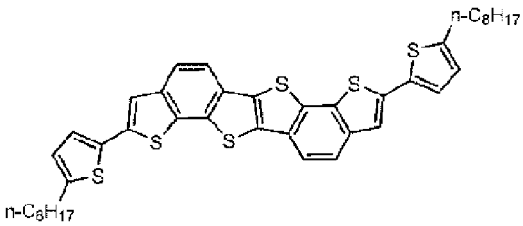

Compound J3

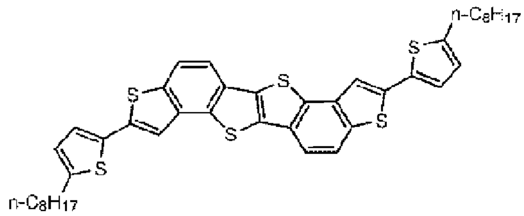

Compound K3

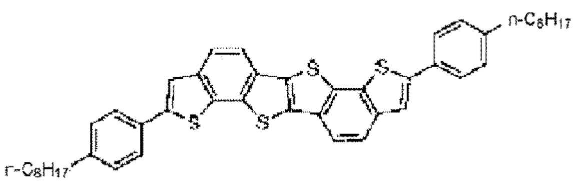

Compound J4

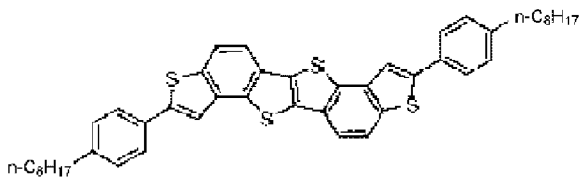

Compound K4

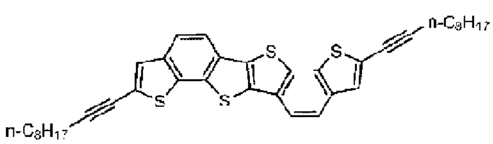

Compound J5

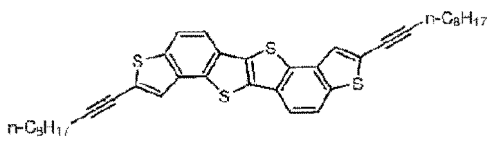

Compound K5

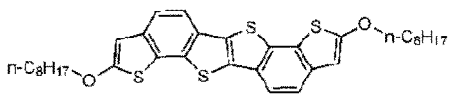

Compound J6

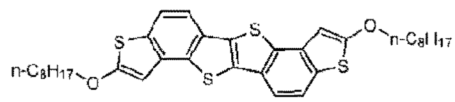

Compound K6

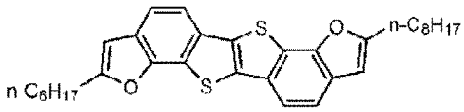

Compound J7

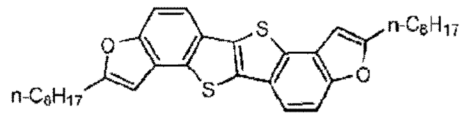

Compound K7

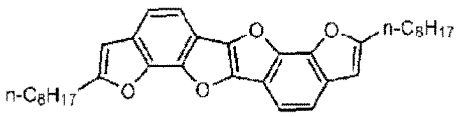

Compound J8

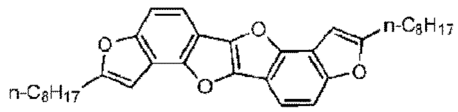

Compound K8

It is preferable that the upper limit of the molecular weight of each of the compound J and the compound K is the same as that of the compound C represented by Formula C, because then the solubility of the compound in a solvent can be improved. In contrast, from the viewpoint of the film quality stability of a thin film, the lower limit of the molecular weight is the same as that of the compound represented by Formula D.

Specific examples of each of the compound L represented by Formula L, the compound M represented by Formula M, the compound N represented by Formula N, the compound P represented by Formula P, and the compound Q represented by the Formula Q will be sequentially shown below.

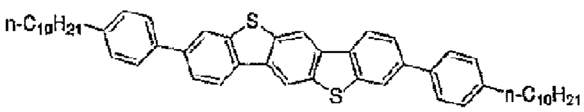

Compound L1

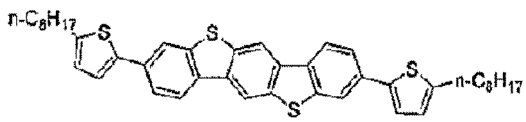

Compound L2

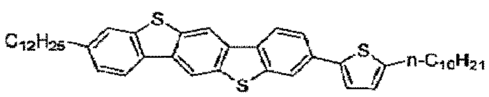

Compound L3

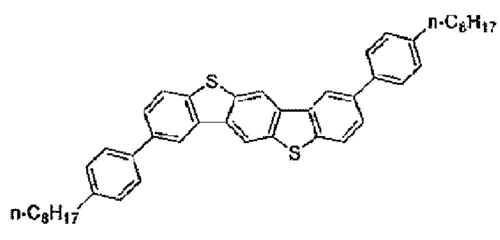

Compound L4

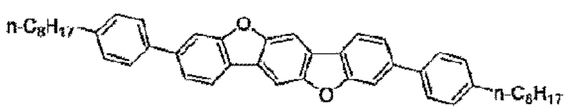

Compound L5

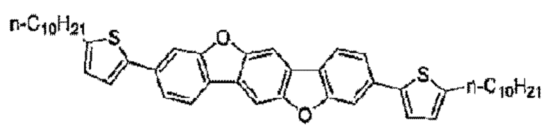

Compound L6

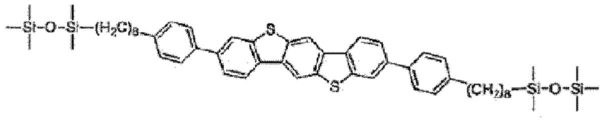

Compound L7

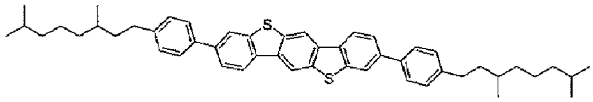

Compound L8

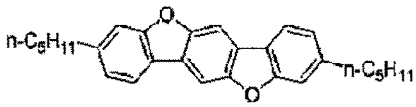

Compound L9

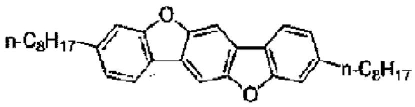

Compound L10

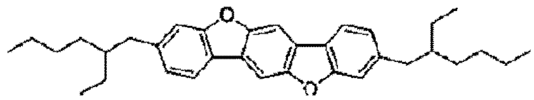

Compound L11

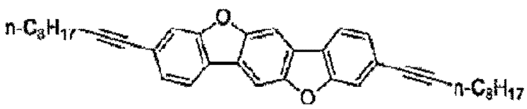

Compound L12

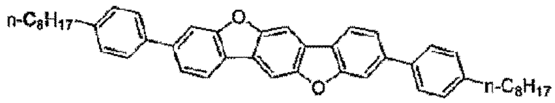

Compound L13

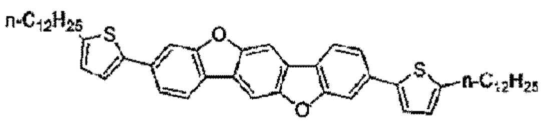

Compound L14

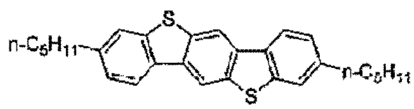

Compound L15

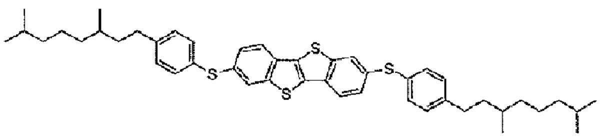

Compound M1

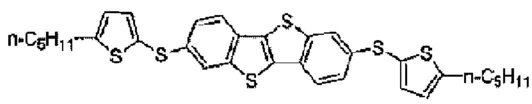

Compound M2

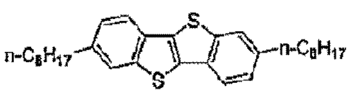

Compound M3 (C8BTBT)

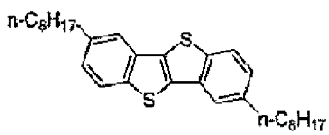

Compound M4

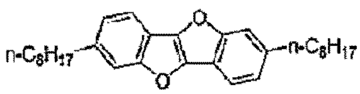

Compound M5

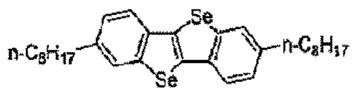

Compound M6

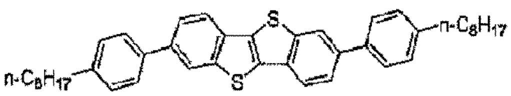

Compound M7

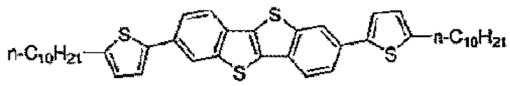

Compound M8

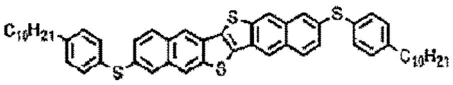

Compound N1

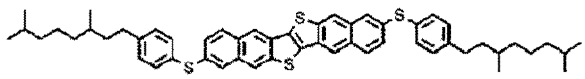

Compound N2

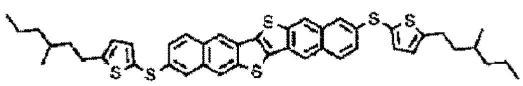

Compound N3

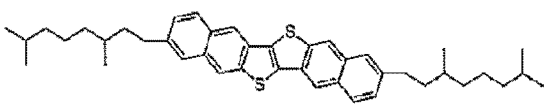

Compound N4

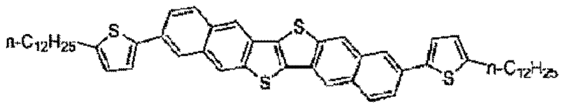

Compound N5

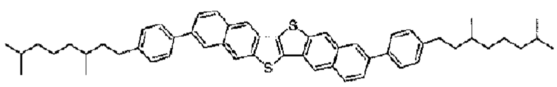

Compound N6

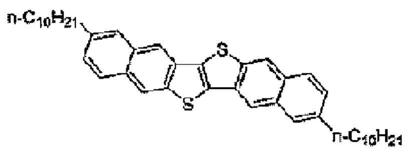

Compound N7

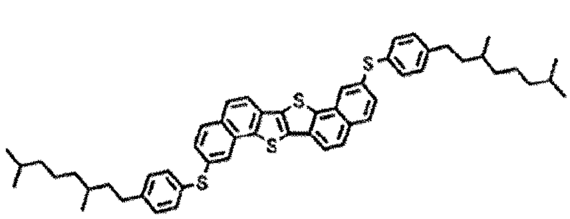

Compound P1

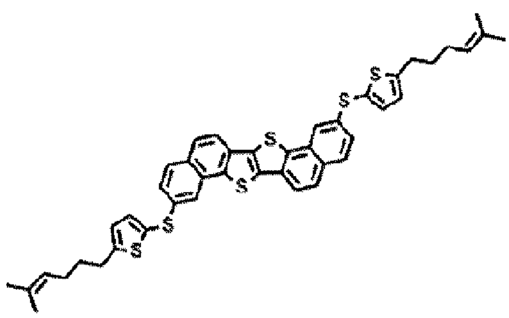

Compound P2

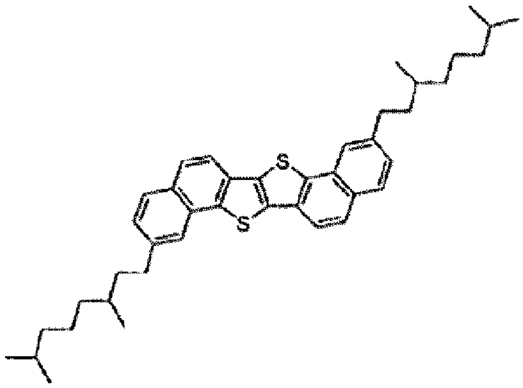

Compound P3

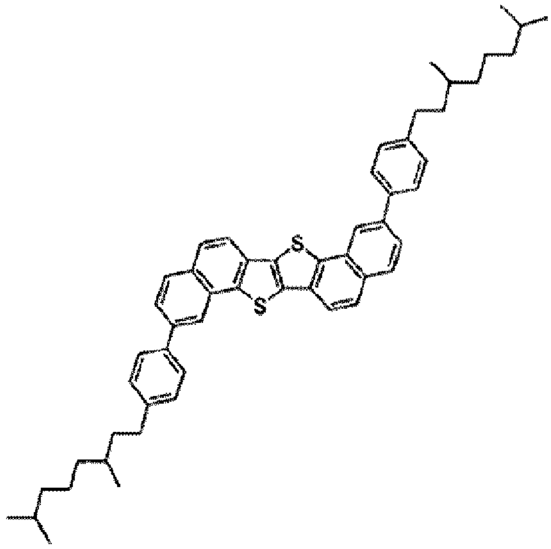

Compound P4

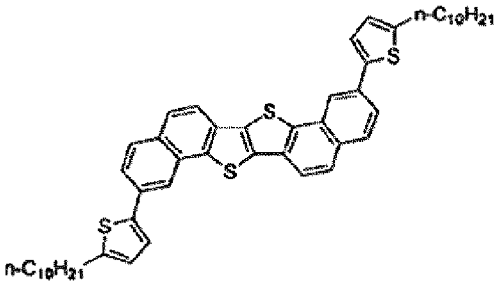

Compound P5

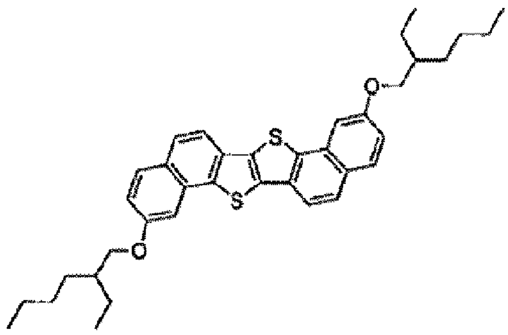

Compound P6

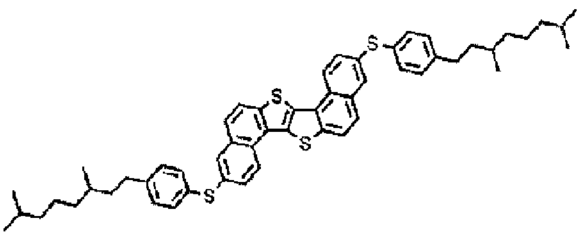

Compound Q1

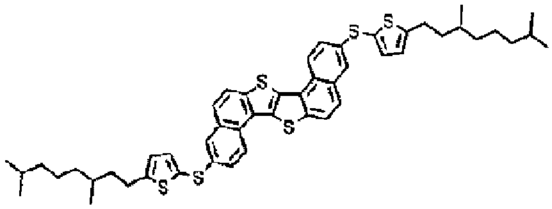

Compound Q2

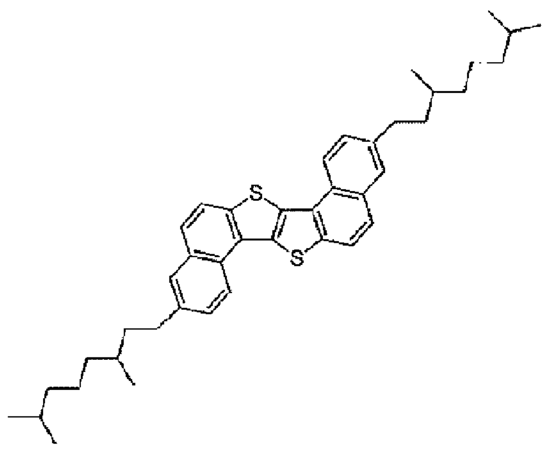

Compound Q3

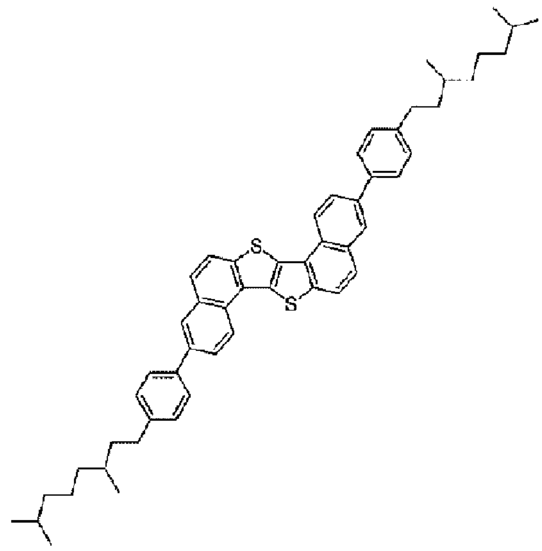

Compound Q4

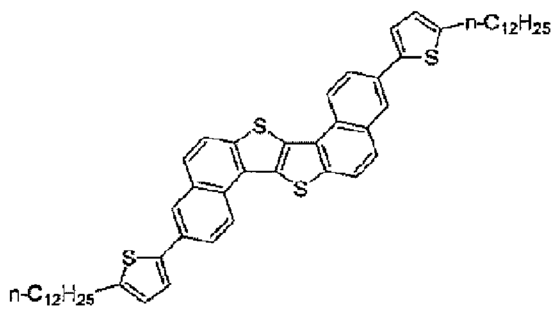

Compound Q5

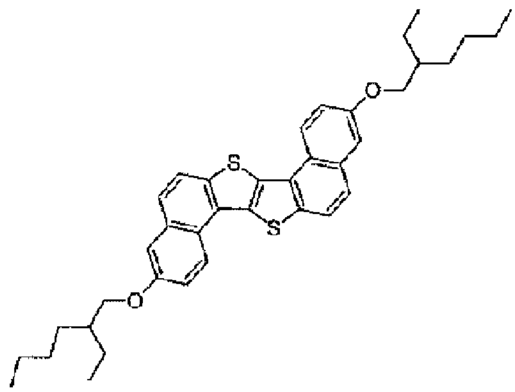

Compound Q6

It is preferable that the upper limit of the molecular weight of each of the compound L, the compound M, the compound N, the compound P, and the compound Q is the same as that of the compound C represented by Formula C, because then the solubility of the compound in a solvent can be improved. In contrast, from the viewpoint of the film quality stability of a thin film, the lower limit of the molecular weight is the same as that of the compound represented by Formula D.

Specific examples of each of the compound R represented by Formula R, the compound S represented by Formula S, and the compound T represented by Formula T will be sequentially shown below.

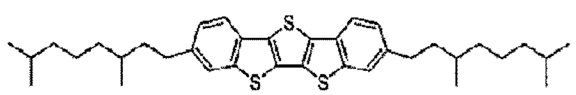

Compound R1

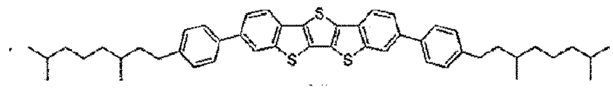

Compound R2

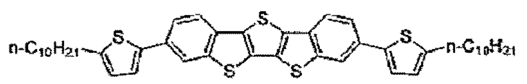

Compound R3

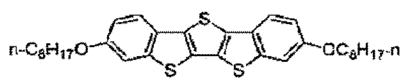

Compound R4

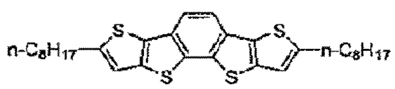

Compound S1

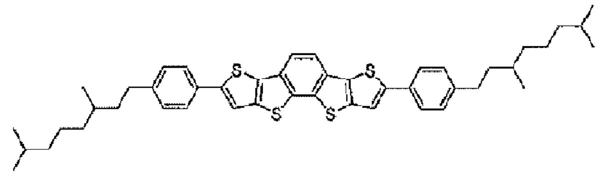

Compound S2

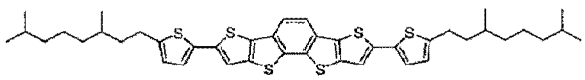

Compound S3

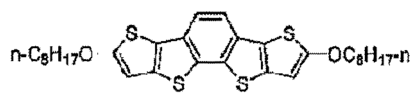

Compound S4

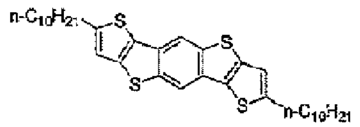

Compound T1

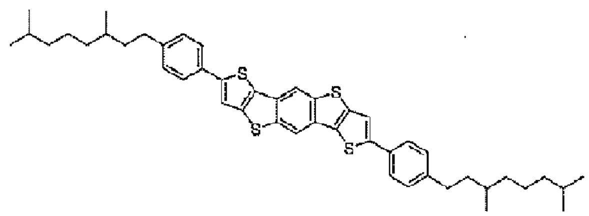

Compound T2

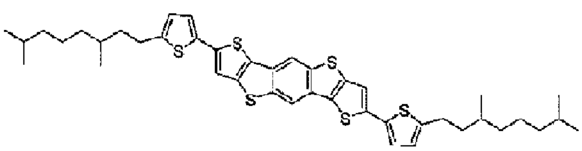

Compound T3

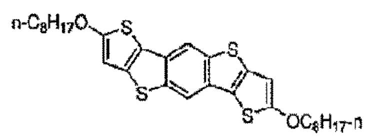

Compound T4

It is preferable that the upper limit of the molecular weight of each of the compound R, the compound S, and the compound T is the same as that of the compound C represented by Formula C, because then the solubility of the compound in a solvent can be improved. In contrast, from the viewpoint of the film quality stability of a thin film, the lower limit of the molecular weight is the same as that of the compound represented by Formula D.

Examples of the organic polymer and a derivative thereof include polypyrrole and derivatives thereof, polydiketopyrrole and derivatives thereof, polythiophene and a derivative thereof, isothianaphthenes such as polyisothianaphthene, thienylene vinylenes such as polythienylene vinylene, poly(p-phenylenevinylenes) such as poly(p-phenylenevinylene), polyaniline and a derivative thereof, a polymer such as polyacetylene, polydiacetylene, polyazulene, polypyrene, polycarbazole, polyselenophene, polyfuran, poly(p-phenylene), polyindole, polypyridazine, polytellurophene, polynaphthalene, polyvinylcarbazole, polyphenylene sulfide, or polyvinylene sulfide, a polymer of a condensed polycyclic aromatic compound, and the like.

The polythiophene and a derivative thereof are not particularly limited, and examples thereof include poly-3-hexylthiophene (P3HT) obtained by introducing a hexyl group into polythiophene, polyethylene dioxythiophene, poly(3,4-ethylenedioxythiophene)/polystyrene sulfonic acid (PEDOT/PSS), and the like.

The examples also include oligomers (for example, oligothiophene) having the same repeating unit as these polymers.

Examples of the organic polymer include polymer compounds in which the compounds represented by Formulae C to H, J to N, and P to T described above have a repeating unit.

Examples of such polymer compounds include $\pi$-conjugated polymers in which the compounds represented by Formulae C to H, J to N, and P to T described above show a repeating unit through at least one or more arylene groups or heteroarylene groups (thiophene, bithiophene, and the like), and pendant-type polymers in which the compounds represented by Formulae C to H, J to N, and P to T are bonded to a polymer main chain through a side chain. As the polymer main chain, polyacrylate, polyvinyl, polysiloxane, and the like are preferable, and as the side chain, an alkylene group, a polyethylene oxide group, and the like are preferable. In a case of the pendant-type polymer, the polymer main chain may be formed by the polymerization of at least one of the substituents $R^C$, $R^D$, $R^E$, $R^F$, $R^G$, $R^H$, $R^I$, $R^J$, $R^K$, $R^L$, $R^M$, $R^N$, $R^O$, $R^P$, $R^Q$, $R^R$, $R^S$, or $R^T$ having a group derived from a polymerizable group.

The weight-average molecular weight of these organic polymers is preferably equal to or greater than 30,000, more preferably equal to or greater than 50,000, and even more preferably equal to or greater than 100,000. If the weight-average molecular weight is equal to or greater than the lower limit described above, the intermolecular interaction can be strengthened, and high mobility is obtained.

The weight-average molecular weight and the number-average molecular weight of the organic polymer are measured by gel permeation chromatography (GPC).

<Second layer>

The second layer is a layer containing a liquid crystal compound.

The thickness of the second layer is preferably 20 to 500 nm, more preferably 25 to 450 nm, and even more preferably 30 to 400 nm.

The liquid crystal compound used in the present invention is not particularly limited as long as the compound undergoes liquid crystal phase transition by heating. Furthermore, from the viewpoint of the heat resistance and the mechanical resistance after the preparation of a thin film, it is preferable that the liquid crystal compound contained in the second layer is polymerized. That is, as the liquid crystal compound used in the second layer in the present invention, a liquid crystal compound having a polymerizable group is preferable. The polymerizable group is not particularly limited, and it is possible to adopt a wide variety of groups such as an ethylenically unsaturated group (that is, a group having an ethylenically unsaturated bond (carbon-carbon double bond) consumed at the time of measuring a bromine index or an iodine index; this group is not an unsaturated group exhibiting aromaticity such as benzene) and a cyclic ether group like an epoxy group or an oxetane group. It is preferable that the ethylenically unsaturated group is introduced as an acryloyl group, a methacryloyl group, an acrylamide group, a vinyl group, a styryl group, or the like. The number of polymerizable groups that the polymerizable liquid crystal compound has is not particularly limited, and for example, it is possible to use a liquid crystal compound having 1 to 6 polymerizable groups in a single molecule. The number of polymerizable groups in a single molecule of the polymerizable liquid crystal compound is more preferably 1 to 5, and even more preferably 1 to 3.

The polymerizable liquid crystal compound used in the present invention may be a discotic liquid crystal compound (referred to as a disk-like liquid crystal compound as well) or a rod-like liquid crystal compound.

[Discotic liquid crystal compound]

In the present invention, a polymerizable discotic liquid crystal compound can be used. As the polymerizable discotic liquid crystal compound, it is possible to use a compound obtained by introducing a polymerizable group into a discotic liquid crystal compound known in the related art. The discotic liquid crystal compound is described in various documents (C. Destrade et at., Mol. Crysr. Liq. Cryst., vol. 71, page 111 (1981); edited by The Chemical Society of Japan, Quarterly Review of Chemistry, No. 22, Chemistry of Liquid Crystal, chapter 5, paragraph 2 of chapter 10 (1994); B. Kohne et al., Angew, Chem. Soc. Chem. Comm., page 1794 (1985); J. Zhang et al., J. Am. Chem. Soc., vol. 116, page 2655 (1994)). The polymerization of the discotic liquid crystal compound is described in, for example, JP1996-27284A (JP-H08-27284A).

Among the compounds described in paragraphs "0038" to "0069" of JP2009-97002A (1,3,5-substituted benzene-type discotic liquid crystal compounds), the compounds in which X represents a group having a polymerizable group can be exemplified as specific examples of the discotic liquid crystal compound having a polymerizable group that can be preferably used in the present invention. Furthermore, among the compounds described in paragraphs "0062" to "0067" of JP2007-108732A, the compounds having a polymerizable group as a substituent can be suitably used in the present invention as the discotic liquid crystal compound having a polymerizable group.

[Rod-like liquid crystal compound]

In the present invention, a polymerizable rod-like liquid crystal compound can be used. As the polymerizable rod-like liquid crystal compound, it is possible to use a compound obtained by introducing a polymerizable group into a rod-like liquid crystal compound known in the related art. As the rod-like liquid crystal compound, azomethines, azoxys, cyanobiphenyls, cyanophenylesters, benzoic acid esters, cyclohexanecarboxylic acid phenyl esters, cyanophenylcyclohexanes, cyano-substituted phenylpyrimidines, alkoxy-substituted phenylpyrimidines, phenyldioxanes, tolanes, and alkenylcyclohexyl benzonitriles are preferably used. In the polymerizable rod-like liquid crystal compound, the number of polymerizable groups in a single molecule is preferably 1 to 6, and more preferably 1 to 3. As the polymerizable rod-like liquid crystal compound, for example, it is possible to use the compounds described in Makromol. Chem., vol. 190, p. 2255 (1989), Advanced Materials, vol. 5, p. 107 (1993), US4683327A, US5622648A, US5770107A, WO95/22586A, WO95/24455A, WO97/00600A, WO98/23580A, WO98/52905A, JP1989-272551A (JP-H01-272551A), JP1994-16616A (JP-H06-16616A), JP1995-110469A (JP-H07-110469A), JP1999-80081A (JP-H11-80081A), and JP2001-328973A.

<Relationship between first layer and second layer>

The ratio of a thickness of the first layer to a total thickness of the first layer and the second layer is preferably equal to or less than 90%, more preferably equal to or less than 80%, even more preferably equal to or less than 50%, particularly preferably equal to or less than 40%, and most preferably equal to or less than 30%.

The lower limit of the ratio of a thickness of the first layer to a total thickness of the first layer and the second layer is not particularly limited, but is preferably equal to or greater than 5%.

The thickness of each layer can be measured by cutting the substrate, on which the first layer and the second layer are formed, in the organic field-effect transistor of the present invention in a direction perpendicular to the plane and observing the cross-section by using a transmission electron microscope.

It is preferable that the first layer and the second layer are formed by lamellar phase separation. The lamellar phase separation is not limited and refers to a state where the layers constituted with different components are spontaneously separated from each other. Examples of the method for forming the first and second layers through lamellar phase separation include a method in which a coating step, a heating step, and a phase separation step in a method for manufacturing an organic semiconductor crystal of the present invention that will be described later are performed in this order.

Whether the first layer and the second layer are in a phase separation state can be confirmed by analyzing a material distribution in a film thickness direction by time-of-flight secondary ion mass spectrometry (TOF-SIMS).

(Method for manufacturing organic semiconductor crystal)

A method for manufacturing an organic semiconductor crystal of the present invention includes a coating step of coating a substrate with a composition containing an organic semiconductor compound, a liquid crystal compound, and an organic solvent such that an organic film is prepared, a heating step of heating the organic film until the organic film enters an isotropic phase, and a phase separation step of causing an organic semiconductor compound layer and a liquid crystal compound layer to undergo lamellar phase separation in a direction parallel to a surface of the substrate by cooling the organic film such that the organic semiconductor compound is crystallized, in this order.

<Coating step>

The method for manufacturing an organic semiconductor crystal of the present invention includes a coating step of coating a substrate with a composition (hereinafter, referred to as a "specific composition" as well) containing an organic semiconductor compound, a liquid crystal compound, and an organic solvent such that an organic film is prepared.

The organic semiconductor compound and the liquid crystal compound have the same definition as the organic semiconductor compound and the liquid crystal compound in the first layer and the second layer described above, and a preferred aspect thereof is also the same.

The content of the organic semiconductor compound with respect to the total mass of the specific composition is preferably 0.01% to 10% by mass, more preferably 0.05% to 5% by mass, and even more preferably 0.1% to 3% by mass.

The content of the liquid crystal compound with respect to the total mass of the specific composition is preferably 0.01% to 20% by mass, more preferably 0.05% to 15% by mass, and even more preferably 0.1% to 10% by mass. If the content is within the above range, coating properties become excellent, and an organic semiconductor film can be easily formed.

[Organic solvent]

The specific composition used in the present invention contains an organic solvent.
As the organic solvent, known organic solvents can be used.
Specific examples of the organic solvent include a hydrocarbon-based solvent such as hexane, octane, decane, toluene, xylene, mesitylene, ethylbenzene, decalin, or 1-methylnaphthalene, a ketone-based solvent such as acetone, methyl ethyl ketone, methyl isobutyl ketone, or cyclohexanone, a halogenated hydrocarbon-based solvent such as dichloromethane, chloroform, tetrachloromethane, dichloroethane, trichloroethane, tetrachloroethane, chlorobenzene, dichlorobenzene, or chlorotoluene, an ester-based solvent such as ethyl acetate, butyl acetate, or amyl acetate, an alcohol-based solvent such as methanol, propanol, butanol, pentanol, hexanol, cyclohexanol, methyl cellosolve, ethyl cellosolve, or ethylene glycol, an ether-based solvent such as dibutyl ether, tetrahydrofuran, dioxane, or anisole, an amide- or imide-based solvent such as N,N-dimethylformamide, N,N-dimethylacetamide, 1-methyl-2-pyrrolidone, or 1-methyl-2-imidazolidinone, a sulfoxide-based solvent such as dimethyl sulfoxide, and a nitrile-based solvent such as acetonitrile.
One kind of these organic solvents may be used singly, or plural kinds thereof may be used in combination.
Among the solvents, an aromatic hydrocarbon-based solvent, a halogenated hydrocarbon-based solvent, a ketone-based solvent and/or ether-based solvent are preferable, toluene, xylene, mesitylene, tetralin, dichlorobenzene, or anisole is more preferable, and toluene is particularly preferable.

[Polymerization initiator]

In a case where the specific composition used in the present invention contains the liquid crystal compound having a polymerizable group, the specific composition preferably further contains a polymerization initiator.
As the polymerization initiator, a photopolymerization initiator is preferable. In a case where the polymerizable group contained in the liquid crystal compound contained in the specific composition is a radically polymerizable group, a photo-radical polymerization initiator is preferable.
The photo-radical polymerization initiator is a compound that can initiator and accelerate the polymerization of a polymerizable compound such as an ethylenically unsaturated group-containing compound by using actinic rays.
The "actinic rays" are not particularly limited as long as they are actinic energy rays being capable of provide energy which can generate an initiation species from the component D by the irradiation thereof, and include a wide variety of rays such as $\alpha$ rays, $\gamma$ rays, X rays, ultraviolet rays (UV), visible rays, and electron beams. Among these, light including at least ultraviolet rays is preferable.
Examples of the photopolymerization initiator include a: aromatic ketones, b: an acylphosphine compound, c: an aromatic onium salt compound, d: an organic peroxide, e: a thio compound, f: a hexaarylbiimidazole compound, g: a ketoxime ester compound, h: a borate compound, i: an azinium compound, j: a metallocene compound, k: an active ester compound, 1: a compound having a carbon halogen bond, m: an alkylamine compound, and the like. The compounds a to m as radical polymerization initiators may be used singly or used in combination. In the present invention, the radical polymerization initiator is suitably used singly or suitably used in combination of two or more kinds thereof.
In the present invention, the specific composition preferably contains a: an aromatic ketones, and more preferably contains an alkylphenone compound. Examples of the alkylphenone compound suitably include commercially available products such as IRGACURE 184 (manufactured by BASF Japan), IRGACURE 369 (manufactured by BASF Japan), IRGACURE 379 (manufactured by BASF Japan), IRGACURE 907 (manufactured by BASF Japan), IRGACURE 2959 (manufactured by BASF Japan), and the like.
From the viewpoint of curability, the content of the polymerization initiator is, with respect to the total mass of the liquid crystal compound, preferably 0.1% to 15% by mass, more preferably 0.5% to 10% by mass, and even more preferably 1% to 5% by mass.

[Substrate]

The type of substrate is not particularly limited, and examples thereof include a plastic substrate, a glass substrate, a ceramic substrate, and the like. Among these, from the viewpoint of applicability to each device and costs, a glass substrate or a plastic substrate is preferable.
Examples of materials of the plastic substrate include a thermosetting resin (for example, an epoxy resin, a phenol resin, a polyimide resin, or a polyester resin (for example, polyethylene terephthalate (PET) or polyethylene naphthalate (PEN)) and a thermoplastic resin (for example, a phenoxy resin, polyethersulfone, polysulfone, or polyphenylene sulfone).
Examples of materials of the ceramic substrate include alumina, aluminum nitride, zirconia, silicon, silicon nitride, silicon carbide, and the like.

Examples of materials of the glass substrate include soda lime glass, potash glass, borosilicate glass, quartz glass, aluminosilicate glass, lead glass, and the like.

It is preferable to form a polymer layer on a surface of the substrate and perform a rubbing treatment. Generally, the rubbing treatment can be performed by rubbing a surface of the polymer layer several times in a certain direction with paper or cloth. Particularly, in the present invention, it is preferable to perform the rubbing treatment by the method described in "Liquid Crystal Handbook" (publisher: MARUZEN Co., Ltd. October 30, 2000, p 226~229). The rubbing treatment makes it easy to align the liquid crystal compound.

As the polymer used in the polymer layer formed on a surface of the substrate, polyvinyl alcohol, polyimide, or polyethylene terephthalate (PET) is preferable.

The polymer layer is preferably formed by coating the substrate surface with a polymer solution. The coating method of the polymer solution is not particularly limited, and known methods can be used. Examples of the method include a bar coating method, a spin coating method, a knife coating method, a doctor blade method, a drop casting method, and the like.

[Composition coating method]

The method for coating the substrate with the composition is not particularly limited, and a known method can be adopted. Examples of the method include an ink jet printing method, a flexographic printing method, a bar coating method, a spin coating method, a knife coating method, a doctor blade method, a drop casting method, and the like. Among these, an ink jet printing method, a flexographic printing method, a spin coating method, and a drop casting method are preferable.

<Heating step>

The method for manufacturing an organic semiconductor crystal of the present invention includes a heat step of heating the aforementioned organic film until the organic film enters an isotropic phase. By the heating step, the organic semiconductor and the liquid crystal compound in the organic film become compatible with each other.

In the heating step, it is preferable to remove the organic solvent from the organic film.

The heating temperature is not particularly limited as long as the used liquid crystal compound enters an isotropic phase at the temperature. The heating temperature is preferably 100°C to 300°C, more preferably 120°C to 280°C, and even more preferably 130°C to 260°C.

The heating time is not particularly limited, and the organic film may be heated until the entirety of the organic film enters an isotropic phase. The heating time is preferably about 30 seconds to 10 minutes.

As the heating method, a known method can be used without particular limitation. It is possible to use a hot plate, an oven, an infrared heater, and the like.

<Phase separation step>

The method for manufacturing an organic semiconductor crystal of the present invention preferably includes a phase separation step of causing an organic semiconductor compound layer and a liquid crystal compound layer to undergo lamellar phase separation in a direction parallel to a surface of the substrate by cooling the organic film such that the organic semiconductor compound is crystallized.

In the phase separation step, the organic film is matured by being held at a temperature (hereinafter, referred to as a "maturing temperature" as well) lower than the temperature of the heating step.

The maturing temperature is not particularly limited as long as the used liquid crystal compound becomes in a liquid crystal state at the temperature. The maturing temperature is preferably 70°C to 150°C, and more preferably 70°C to 130°C.

The maturing time is not particularly limited, and it is preferable that the organic film is matured until the organic semiconductor compound and the liquid crystal compound in the organic film undergo lamellar phase separation. The maturing time is preferably 30 seconds to 10 minutes.

As the heating method, the same heating method as in the heating step can be used.

<Polymerization step>

From the viewpoint of heat resistance of the liquid crystal compound layer, the method for manufacturing an organic semiconductor crystal of the present invention preferably includes a polymerization step of polymerizing the liquid crystal compound layer such that the layer is fixed.

The polymerization step is preferably performed after the phase separation step.

In a case where the method for manufacturing an organic semiconductor crystal of the present invention includes the polymerization step, the liquid crystal compound layer formed in the phase separation step preferably contains a polymerizable group-containing liquid crystal compound and a polymerization initiator, and more preferably contains a radically polymerizable group-containing liquid crystal compound, and a photo-radical polymerization initiator. From the viewpoint of curability, the aforementioned radical polymerizable group is preferably a (meth)acryloyl group.

In a case where the liquid crystal compound layer contains a radically polymerizable group-containing liquid crystal compound and a photo-radical polymerization initiator, by cooling the organic film down to a UV irradiation temperature after maturing in the phase separation step and irradiating the organic film with actinic rays, the liquid crystal compound layer can be fixed by polymerization.

The UV irradiation temperature is not particularly limited, but is preferably 30°C to 80°C and more preferably 40°C to 70°C.

As an irradiation light source used for the irradiation of actinic rays, it is possible to use a low-pressure mercury lamp, a high-pressure mercury lamp, an ultrahigh-pressure mercury lamp, a chemical lamp, an LED light source, an eximer laser generating device, and the like. Furthermore, it is possible to use actinic rays having a wavelength of equal to or greater than 300 nm and equal to or less than 450 nm, such as g line (436 nm), i line (365 nm), or h line (405 nm). If necessary, the irradiation light can be adjusted through a spectral filter such as a long-wavelength cut-off filter, a short-wavelength cut-off filter, or a bandpass filter.

As the irradiation device, it is possible to use irradiation machines using various methods such as a mirror projection aligner, a stepper, a scanner, proximity, contact, a microlens array, and laser irradiation.

The irradiation amount is preferably 100 to 3,000 mJ/$cm^2$, and particularly preferably 100 to 1,000 mJ/$cm^2$.

(Organic semiconductor element, organic field-effect transistor, method for manufacturing these)

An organic semiconductor element of the present invention has an organic semiconductor layer containing an organic semiconductor crystal manufactured by the method for manufacturing an organic semiconductor crystal, a gate electrode, a source electrode, a drain electrode, a gate insulating layer insulating the source electrode and the drain electrode from the gate electrode, and a substrate supporting these.

The organic semiconductor element of the present invention is an organic field-effect transistor.

The gate insulating layer may be in the form of a film, and the gate insulating layer in the form of a film is referred to as a gate insulating film as well.

An aspect of the organic field-effect transistor of the present invention will be described with reference to a drawing.

Fig. 1 is a schematic cross-sectional view of an aspect of the organic semiconductor element (organic thin film transistor (TFT)) of the present invention.

In Fig. 1, an organic thin film transistor 100 includes a substrate 10, a liquid crystal compound layer 52 and an organic semiconductor film 50 disposed on the substrate 10, a source electrode 40 and a drain electrode 42 contacting the organic semiconductor, a gate insulating film 30 formed on the source electrode 40 and the drain electrode 42, a gate electrode 20 formed on the gate insulating film 30, and a sealing layer 60 covering each member. The organic thin film transistor 100 is a top gate-top contact type organic field-effect transistor.

In Fig. 1, the organic semiconductor film 50 corresponds to the first layer of the organic field-effect transistor of the present invention, and the liquid crystal compound layer 52 corresponds to the second layer of the organic field-effect transistor. The organic semiconductor film 50 and the liquid crystal compound layer 52 are preferably formed by causing the specific composition to undergo lamellar phase separation.

Hereinafter, the substrate, the gate electrode, the gate insulating film, the source electrode, the drain electrode, the sealing layer, and methods for forming these will be specifically described.

[Substrate]

The substrate plays a role of supporting the organic semiconductor layer and the liquid crystal compound layer or the gate electrode, the source electrode, the drain electrode and the like which will be described later.

The substrate has the same definition as the substance described as a substrate in the aforementioned coating step, and a preferred aspect thereof is also the same.

[Gate electrode, source electrode, and drain electrode]

Examples of materials of the gate electrode, the source electrode, and the drain electrode include a metal such as gold (Au), silver, aluminum (Al), copper, chromium, nickel, cobalt, titanium, platinum, tantalum, magnesium, calcium, barium, or sodium; a conductive oxide such as $InO_2$, $SnO_2$, or indium tin oxide (ITO); a conductive polymer such as

polyaniline, polypyrrole, polythiophene, polyacetylene, or polydiacetylene; a semiconductor such as silicon, germanium, or gallium arsenide; a carbon material such as fullerene, carbon nanotubes, or graphite; and the like. Among these, a metal is preferable, and silver and aluminum are more preferable.

The thickness of each of the gate electrode, the source electrode, and the drain electrode is not particularly limited, but is preferably 20 to 200 nm.

The method for forming the gate electrode, the source electrode, and the drain electrode is not particularly limited, but examples thereof include a method of vacuum vapor-depositing or sputtering an electrode material onto the organic semiconductor layer or the insulating layer, a method of coating a substrate with a composition for forming an electrode, a method of printing a composition for forming an electrode onto the organic semiconductor layer or the insulating layer, and the like. Furthermore, in a case where the electrode is patterned, examples of the patterning method include a photolithography method; a printing method such as ink jet printing, screen printing, offset printing, or relief printing; a mask vapor deposition method; and the like.

[Gate insulating film]

Examples of materials of the gate insulating film include a polymer such as polymethyl methacrylate, polystyrene, polyvinylphenol, polyimide, polycarbonate, polyester, polyvinylalcohol, polyvinyl acetate, polyurethane, polysulfone, polybenzoxazole, polysilsesquioxane, an epoxy resin, or a phenol resin; an oxide such as silicon dioxide, aluminum oxide, or titanium oxide; a nitride such as silicon nitride; and the like. Among these materials, in view of the compatibility with the organic semiconductor film, a polymer is preferable.

In a case where a polymer is used as the material of the gate insulating film, it is preferable to use a cross-linking agent (for example, melamine) in combination. If the cross-linking agent is used in combination, the polymer is cross-linked, and durability of the formed gate insulating film is improved.

The film thickness of the gate insulating film is not particularly limited, but is preferably 100 to 1,000 nm.

The method for forming the gate insulating film is not particularly limited, but examples thereof include a method of coating a the organic semiconductor layer, on which the source electrode and the drain electrode are formed, with a composition for forming a gate insulating film, a method of vapor-depositing or sputtering the material of the gate insulating film onto the organic semiconductor layer, and the like. The method for coating the aforementioned organic semiconductor layer with the composition for forming a gate insulating film is not particularly limited, and it is possible to use a known method (a bar coating method, a spin coating method, a knife coating method, or a doctor blade method).

In a case where the gate insulating film is formed by coating the organic semiconductor layer with the composition for forming a gate insulating film, for the purpose of removing the solvent, causing cross-linking, or the like, the composition may be heated (baked) after coating.

[Sealing layer]

From the viewpoint of durability, the organic semiconductor element of the present invention preferably includes a sealing layer as an outermost layer. In the sealing layer, a known sealant can be used.

The thickness of the sealing layer is not particularly limited, but is preferably 0.2 to 10 $\mu$m.

The method for forming the sealing layer is not particularly limited, but examples thereof include a method of coating a substrate, on which the gate electrode, the gate insulating film, the source electrode, the drain electrode, and the organic semiconductor film are formed, with a composition for forming a sealing layer, and the like. Specific examples of the method of coating the substrate with the composition for forming a sealing layer are the same as the examples of the method of coating the substrate with the composition for forming a gate insulating film. In a case where the organic semiconductor film is formed by coating the substrate with the composition for forming a sealing layer, for the purpose of removing the solvent, causing cross-linking, or the like, the composition may be heated (baked) after coating.

Fig. 2 is a schematic cross-sectional view of another aspect of the organic semiconductor element (organic thin film transistor) of the present invention.

In Fig. 2, an organic thin film transistor 200 includes the substrate 10, the gate electrode 20 disposed on the substrate 10, the gate insulating film 30 covering the gate electrode 20, the organic semiconductor film 50 disposed on the gate insulating film 30, the source electrode 40 and the drain electrode 42 disposed on the organic semiconductor film 50, and the sealing layer 60 covering each member. A liquid crystal compound layer adjacent to the organic semiconductor film 50 is present between the organic semiconductor film 50 and the gate insulating film 30, although the liquid crystal compound layer is not shown in the drawing. Herein, the source electrode 40 and the drain electrode 42 are formed using the aforementioned composition of the present invention. The organic thin film transistor 200 is a bottom gate-top contact type organic thin film transistor.

The substrate, the gate electrode, the gate insulating film, the source electrode, the drain electrode, the organic semiconductor film, and the sealing layer are as described above.

In Figs. 1 and 2, the aspects of the top gate-top contact type organic thin film transistor and the bottom gate-top contact type organic thin film transistor were specifically described. However, the organic semiconductor element of the present invention can also be suitably used in a top gate-bottom contact type organic thin film transistor and a bottom gate-bottom contact type organic thin film transistor.
The aforementioned organic thin film transistor can be suitably used in electronic paper, a display device, and the like.

Examples

Hereinafter, the present invention will be more specifically described based on examples. Herein, unless otherwise specified, "part" and "%" are based on mass.
The details of the components used in each example and comparative example are as below.

<Organic semiconductor compound>

- OSC-1 (compound having the following structure)
- OSC-2 (compound having the following structure)
- OSC-3 (compound having the following structure)

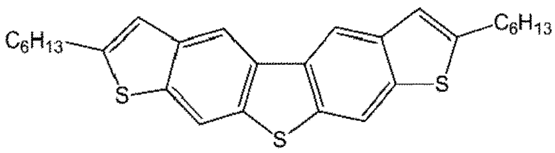

OSC-1

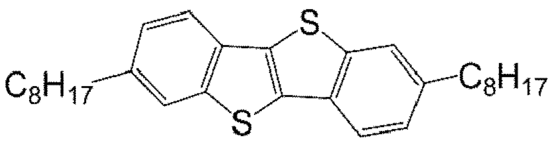

OSC-3

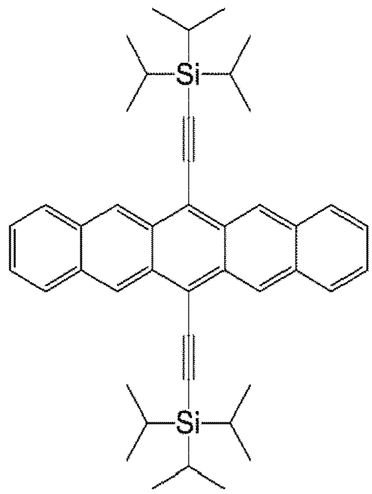

OSC-2

The compound OSC-1 can be synthesized by the method described in Tetrahedron 66 (2010) 8778~8784.
As OSC-2, 6,13-bis(triisopropylsilylethynyl)pentacene (manufactured by TOKYO CHEMICAL INDUSTRY CO., LTD.) was used.
As OSC-3, C8BTBT (manufactured by Nippon Kayaku Co., Ltd.) was used.

<Liquid crystal compound>

- LCC-A (rod-like liquid crystal compound having the following structure) was synthesized by the method described in JP2001-328973A.
- LCC-B (discotic liquid crystal compound having the following structure) was synthesized by the method described in JP2009-97002A.

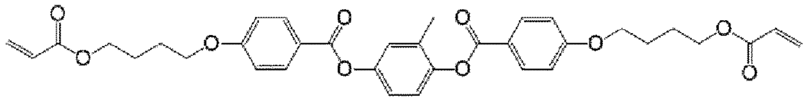

LCC-A

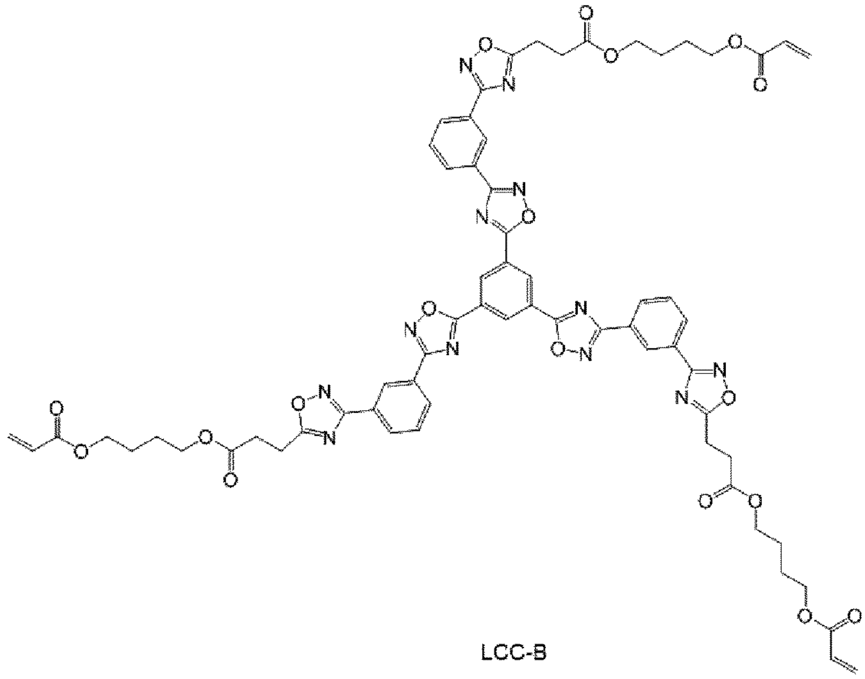

LCC-B

<Polymerization initiator>

- IRGACURE 907 (2-methyl-1-(4-methylthiophenyl)-2-morpholinopropan-1-one, manufactured by BASF SE, molecular weight: 297)

<Organic solvent>

- Toluene (manufactured by Wako Pure Chemical Industries, Ltd.)

(Preparation of coating solution containing organic semiconductor)

Each of the components described in the following Table 1 was mixed together at a proportion described in Table 1, thereby preparing coating solutions T1 to T22 containing an organic semiconductor.

The polymerization initiator was added at a ratio of 3% by mass with respect to the total mass of the liquid crystal compound. Herein, the coating solution for which "N/A" is marked in the columns of the liquid crystal compound and the polymerization initiator means that coating solution does not contain the corresponding component.

[Table 1]

| Coating solution | Organic semiconductor compound | Concentration of solid content (% by mass) | Liquid crystal compound | Concentration of solid content (% by mass) | Polymerization initiator | Organic solvent |
|---|---|---|---|---|---|---|
| T1 | OSC-1 | 0.25 | LCC-A | 7 | Irgacure 907 | Toluene |
| T2 | | | | 3.5 | | |
| T3 | | | | 2 | | |
| T4 | | | | 1 | | |
| T5 | | | | 0.5 | | |
| T6 | | | | 0.25 | | |
| T7 | OSC-2 | 0.5 | | 3 | | |
| T8 | OSC-3 | 0.5 | | 3 | | |
| T9 | OSC-1 | 0.25 | LCC-B | 5 | | |
| T10 | | 0.5 | | | | |
| T11 | | | | 7 | | |
| T12 | OSC-1 | 0.4 | LCC-A | 0.1 | | |
| T13 | | | | 0.2 | | |
| T14 | OSC-2 | 0.5 | | 0.1 | | |
| T15 | | | | 0.25 | | |
| T16 | OSC-3 | 0.5 | | 0.1 | | |
| T17 | | | | 0.25 | | |
| T18 | OSC-1 | 0.4 | LCC-B | 0.1 | | |
| T19 | | | | 0.2 | | |
| T20 | OSC-1 | 0.4 | N/A | - | N/A | |
| T21 | OSC-2 | 0.5 | | - | | |
| T22 | OSC-3 | 0.5 | | - | | |

(Preparation of coating substrate)

A glass substrate was spin-coated (2,000 rpm/20 sec.) with a 2% by mass polyimide (SE-130) solution (N-methylpyrrolidone) manufactured by NISSAN CHEMICAL INDUSTRIES, LTD., subjected to pre-drying for 5 minutes at 110°C, and then subjected to imidation treatment by being thermally treated for 60 minutes at 240°C, thereby obtaining a coating substrate B1.

A polyimide film surface of the coating substrate B1 was subjected to a rubbing treatment by using cotton cloth, thereby obtaining a coating substrate B2.

(Preparation of sample for crystal evaluation)

The coating substrate described in Table 2 was spin-coated (500 rpm/2 min) with the coating solution described in Table 1, thereby preparing a coating film. Then, the coating film was held at the thermal treatment temperature described in Table 2 for 1 minute and then cooled down to a maturing temperature, and the crystal was matured for 2 minutes. In a case where "N/A" is marked in the column of the maturing temperature of Table 2, it means that maturing was not performed. After being cooled down to a UV irradiation temperature, the coating film was irradiated with ultraviolet rays having a wavelength of around 365 nm of an ultrahigh-pressure mercury lamp at 540 mJ/$cm^2$ such that the organic film was polymerized and fixed. In a case where "N/A" is marked in the column of the UV irradiation temperature of Table 2, it means that UV irradiation was not performed.

(Thickness of organic semiconductor layer and liquid crystal layer)

In each of the examples and comparative examples, the prepared sample for crystal evaluation was cut in a vertical direction, and the cross-section was observed with a transmission electron microscope, thereby measuring the thickness of the organic semiconductor layer and the thickness of the liquid crystal layer. The results are shown in Table 2. A ratio (%) of the thickenss of the organic semiconductor layer to the total thickness of the organic semiconductor layer and the liquid crystal layer is described in the column of ratio (%) of organic semiconductor layer.

In Table 2, in a case where "-" is marked in the column of the thickness of liquid crystal layer, it means that the liquid crystal layer could not be observed. In this case, "-" is also marked in the column of the ratio (%) of organic semiconductor layer.

(Observation of crystal size)

By using an E600 POL polarizing microscope manufactured by Nikon Corporation, the sample was observed using a 10x objective lens and a 10x ocular lens, and the crystal size was measured using a measure for a microscope. The visual field area equaled a circle having a diameter of 2 mm. The evaluation standard will be shown below. The sample evaluated to be 1 or 2 is unproblematic for practical use, and it is preferable that the sample is evaluated to be 1. In each of the examples and comparative examples, the crystal sizes of a plurality of crystals in the visual field of the microscope were substantially the same as each other.

1: greater than 500 μm × 500 μm
2: 100 μm × 100 μm to 500 μm × 500 μm
3: less than 100 μm × 100 μm

(Observation of crystal alignment)

The sample was placed under the same microscope as described above, the stage was rotated under a crossed Nicol prism such that the crystal became in an extinction position in a dark field, and the alignment state was evaluated. The evaluation standard will be shown below. The sample evaluated to be 1 or 2 is unproblematic for practical use, and it is preferable that the sample is evaluated to be 1.

1: The crystals were aligned in the same direction within the entirety of the visual field.
2: Approximately half of the crystals were aligned in the same direction within the visual field.
3: The alignment could not be confirmed.

(Preparation of top gate-top contact type element)

Gold (thickness: 50 nm) was vacuum vapor-deposited onto the upper surface of an organic semiconductor film prepared by the same method as used for preparing the sample for crystal evaluation, thereby preparing source and drain electrodes having a channel length of 50 μm and a channel width of 200 μm. The electrodes were spin-coated with CYTOP (manufactured by ASAHI GLASS CO., LTD.) as an insulating film having a thickness of 200 nm, and gold (thickness: 50 nm) was vacuum vapor-deposited thereon, thereby preparing a gate electrode.

(Measurement of mobility)

By using a semiconductor parameter analyzer (4156C manufactured by Agilent Technologies) connected to a semi-automatic prober (AX-2000 manufactured by Vector Semiconductor Co., Ltd.), the carrier mobility of the top gate-top contact type element was evaluated under a normal pressure/nitrogen atmosphere.

Between the source electrode and the drain electrode of each element, a voltage of -80 V was applied, and the gate voltage was varied within a range of 20 V to -100 V. In this way, a carrier mobility μ was calculated using the following equation showing a drain current $I_d$.

$$Id = (w/2L)\mu C_i(Vg - Vth)^2$$

In the equation, L represents a gate length, W represents a gate width, Ci represents a capacity of the insulating layer per unit area, Vg represents a gate voltage, and Vth represents a threshold voltage.

The evaluation standard will be shown below. The sample evaluated to be 1 or 2 is unproblematic for practical use, and it is preferable that the sample is evaluated to be 1.

1: greater than 1 $cm^2/Vs$
2: 0.5 $cm^2/Vs$ to 1 $cm^2/Vs$
3: less than 0.5 $cm^2/Vs$

(Example 1)

By using the coating solution T1 and the coating substrate B2, a sample S1 was prepared at a heating temperature of 150°C, a maturing temperature of 90°C, and a UV irradiation temperature of 60°C. A polarizing micrograph of the obtained organic semiconductor crystal is shown in Fig. 3. The crystal size was about 2 mm × 2 mm, and the crystals were aligned in the same direction within the entire region of the visual field. Furthermore, as a result of checking the material distribution in the film thickness direction by TOF-SIMS (TRIFTV nano TOF manufactured by ULVAC-PHI, INCORPORATED.), it was possible to confirm that the organic semiconductor layer and the liquid crystal layer were in a phase separation state. The material distribution is shown in Fig. 5. The organic semiconductor layer and the liquid crystal layer had a film thickness of 30 nm and 360 nm respectively, and the ratio of the organic semiconductor layer was 7.7%. The mobility of the top gate-top contact type element of the sample S1 was 3 $cm^2/Vs$. Other evaluation results are described in Table 2.

(Examples 2 to 19)

Examples 2 to 19 were performed in the same manner as in Example 1, except that the coating solutions T2 to T19 were used, and the coating substrate, the heating temperature, the maturing temperature, and the UV irradiation temperature were changed as described in Table 2. As a result of checking the material distribution in the film thickness direction by TOF-SIMS, it was possible to confirm that the organic semiconductor layer and the liquid crystal layer were in a phase separation state in all of the examples. The evaluation results are described in Table 2.

(Comparative Example 1)

By using the coating solution T20 and the coating substrate B1, a sample S20 was prepared by drying the solvent for 1 hour at 60°C instead of maturing the crystals as in Example 1. The crystal size of equal to or less than 100 μm × 100 μm, and the crystals substantially were not aligned. A polarizing micrograph of the obtained organic semiconductor crystal is shown in Fig. 4. The organic semiconductor layer had a film thickness of 50 nm. The mobility of the top gate-top contact type element of the sample S20 was 0.07 $cm^2/Vs$. Other evaluation results are described in Table 2.

(Comparative Examples 2 and 3)

Comparative Examples were performed in the same manner as in Comparative Example 1, except that T21 or T22 was used as a coating solution. The evaluation results are described in Table 2.

[Table 2]

| | Sample | Coating solution | Coating substrate | Heating temperature (°C) | Maturing temperature (°C) | UV irradiation temperature (°C) | Thickness of organic semiconductor layer (nm) | Thickness of liquid crystal layer (nm) | Ratio of organic semiconductor layer (%) | Crystal size | Crystal alignment | Mobility |
|---|---|---|---|---|---|---|---|---|---|---|---|---|
| Example 1 | S1 | T1 | | 150 | 90 | | 30 | 360 | 7.7 | 1 | 1 | 1 |
| Example 2 | S2 | T2 | | 170 | 120 | | 30 | 170 | 15 | 1 | 1 | 1 |
| Example 3 | S3 | T3 | | 210 | 130 | | 30 | 140 | 17.6 | 1 | 1 | 1 |
| Example 4 | S4 | T4 | B2 | 220 | 130 | | 30 | 120 | 20 | 1 | 1 | 1 |
| Example 5 | S5 | T5 | | 240 | 130 | | 30 | 50 | 37.5 | 1 | 1 | 1 |
| Example 6 | S6 | T6 | | 260 | 130 | 60 | 30 | 30 | 50 | 1 | 1 | 1 |
| Example 7 | S7 | T7 | | 170 | 90 | | 50 | 150 | 25 | 1 | 1 | 2 |
| Example 8 | S8 | T8 | | 130 | 80 | | 50 | 150 | 25 | 1 | 1 | 2 |
| Example 9 | S9 | T9 | | 170 | 130 | | 30 | 250 | 10.7 | 2 | 2 | 2 |
| Example 10 | S10 | T10 | | 190 | 130 | | 50 | 250 | 16.7 | 2 | 2 | 2 |
| Example 11 | S11 | T11 | | 180 | 130 | | 50 | 360 | 12.2 | 2 | 2 | 2 |
| Example 12 | S12 | T12 | | 250 | 110 | | 50 | 15 | 77 | 1 | 1 | 2 |
| Example 13 | S13 | T13 | | 230 | 110 | | 50 | 25 | 66.7 | 1 | 1 | 2 |
| Example 14 | S14 | T14 | | 215 | 100 | | 60 | 15 | 80 | 1 | 1 | 2 |
| Example 15 | S15 | T15 | | 195 | 100 | 60 | 60 | 30 | 66.7 | 1 | 1 | 2 |
| Example 16 | S16 | T16 | B1 | 120 | 90 | | 60 | 15 | 80 | 1 | 1 | 2 |
| Example 17 | S17 | T17 | | 120 | 90 | | 60 | 30 | 66.7 | 1 | 1 | 2 |
| Example 18 | S18 | T18 | | 255 | 110 | | 50 | 15 | 77 | 2 | 2 | 2 |
| Example 19 | S19 | T19 | | 245 | 110 | | 50 | 25 | 66.7 | 2 | 2 | 2 |
| Comparative Example 1 | S20 | T20 | | | | | 50 | - | - | 3 | 3 | 3 |
| Comparative Example 2 | S21 | T21 | | 60 | N/A | N/A | 60 | - | - | 3 | 3 | 3 |

(continued)

| | Sample | Coating solution | Coating substrate | Heating temperature (°C) | Maturing temperature (°C) | UV irradiation temperature (°C) | Thickness of organic semiconductor layer (nm) | Thickness of liquid crystal layer (nm) | Ratio of organic semiconductor layer (%) | Crystal size | Crystal alignment | Mobility |
|---|---|---|---|---|---|---|---|---|---|---|---|---|
| Comparative Example 3 | S22 | T22 | | | | | 60 | - | - | 3 | 3 | 3 |

Explanation of References

| | |
|---|---|
| 10: | substrate |
| 20: | gate electrode |
| 30: | gate insulating film |
| 40: | source electrode |
| 42: | drain electrode |
| 50: | organic semiconductor film |
| 52: | liquid crystal layer |
| 60: | sealing layer |
| 100, 200: | organic thin film transistor |

## Claims

**1.** An organic field-effect transistor comprising:

a first layer which consists of an organic semiconductor compound; and **characterised in that** it further comprises a second layer which is adjacent to the first layer and consists of a liquid crystal compound,
wherein an organic semiconductor monocrystal in the first layer has a size of equal to or greater than 100 $\mu$m $\times$ 100 $\mu$m.

**2.** The organic field-effect transistor according to claim 1,
wherein a ratio of a thickness of the first layer to a total thickness of the first layer and the second layer is equal to or less than 50%.

**3.** The organic field-effect transistor according to claim 1 or 2,
wherein the liquid crystal compound contained in the second layer is polymerized.

**4.** A method for manufacturing an organic semiconductor crystal, comprising:

a coating step of coating a substrate with a composition containing an organic semiconductor compound, a liquid crystal compound, and an organic solvent such that an organic film is prepared;
a heating step of heating the organic film until the organic film enters an isotropic phase; and
a phase separation step of causing an organic semiconductor compound layer and a liquid crystal compound layer to undergo lamellar phase separation in a direction parallel to a surface of the substrate by cooling the organic film such that the organic semiconductor compound is crystallized, in this order.

**5.** The method for manufacturing an organic semiconductor crystal according to claim 4, further comprising:
a polymerization step of polymerizing the liquid crystal compound layer such that the layer is fixed.

**6.** The organic field-effect transistor according to any one of claims 1 to 3, further comprising:

a gate electrode;
a source electrode;
a drain electrode;
a gate insulating layer insulating the source electrode and the drain electrode from the gate electrode, and
a substrate supporting these.

## Patentansprüche

**1.** Organischer Feldeffekttransistor, umfassend:

eine erste Schicht, die aus einer organischen Halbleiterverbindung besteht; und
**dadurch gekennzeichnet, dass** er ferner eine zweite Schicht umfasst, welche an die erste Schicht angrenzt

und aus einer Flüssigkristallverbindung besteht,
worin ein organischer Halbleiter-Einkristall in der ersten Schicht eine Größe von gleich oder größer 100 $\mu$m $\times$ 100 $\mu$m aufweist.

**2.** Organischer Feldeffekttransistor gemäß Anspruch 1, worin das Verhältnis der Dicke der ersten Schicht zur Gesamtdicke der ersten Schicht und der zweiten Schicht gleich oder größer 50 % beträgt.

**3.** Organischer Feldeffekttransistor gemäß Anspruch 1 oder 2, worin die in der zweiten Schicht enthaltene Flüssigkristallverbindung polymerisiert ist.

**4.** Verfahren zur Herstellung eines organischen Halbleiterkristalls, umfassend in dieser Reihenfolge:

einen Beschichtungsschritt zum Beschichten eines Substrats mit einer Zusammensetzung, die eine organische Halbleiterverbindung, eine Flüssigkristallverbindung und ein organisches Lösungsmittel umfasst, so dass ein organischer Film hergestellt wird;
einen Erwärmungsschritt zum Erwärmen des organischen Films, bis der organische Film in eine isotrope Phase übertritt; und
einen Phasentrennungsschritt, in dem verursacht wird, dass eine organische Halbleiterverbindungsschicht und eine Flüssigkristallverbindungsschicht eine lamellare Phasentrennung in einer Richtung parallel zur Oberfläche des Substrats eingehen, indem der organische Film so gekühlt wird, dass die organische Halbleiterverbindung kristallisiert.

**5.** Verfahren zur Herstellung eines organischen Halbleiterkristalls gemäß Anspruch 4, ferner umfassend:
einen Polymerisationsschritt zum Polymerisieren der Flüssigkristallverbindungsschicht, so dass die Schicht fixiert wird.

**6.** Organischer Feldeffekttransistor gemäß irgendeinem der Ansprüche 1 bis 3, ferner umfassend:

eine Gate-Elektrode;
eine Source-Elektrode;
eine Drain-Elektrode;
eine Gate-Isolierschicht, die die Source-Elektrode und die Drain-Elektrode von der Gate-Elektrode isoliert, und einen Träger, der diese trägert.

## Revendications

**1.** Transistor organique à effet de champ comprenant :

une première couche qui consiste en un composé organique semi-conducteur ; et **caractérisé en ce qu'**il comprend en outre
une seconde couche qui est adjacente à la première couche et consiste en un composé à cristaux liquides,
dans lequel un monocristal organique semi-conducteur dans la première couche présente une taille égale ou supérieure à 100 $\mu$m $\times$ 100 $\mu$m.

**2.** Transistor organique à effet de champ selon la revendication 1,
dans lequel un rapport entre une épaisseur de la première couche et une épaisseur totale de la première couche et de la seconde couche est égal ou inférieur à 50%.

**3.** Transistor organique à effet de champ selon la revendication 1 ou 2,
dans lequel le composé à cristaux liquides contenu dans la seconde couche est polymérisé.

**4.** Procédé pour fabriquer un cristal organique semi-conducteur, comprenant :

une étape de revêtement consistant à revêtir un substrat avec une composition contenant un composé organique semi-conducteur, un composé à cristaux liquides et un solvant organique de telle sorte qu'un film organique est préparé ;
une étape de chauffage consistant à chauffer le film organique jusqu'à ce que le film organique entre dans une

phase isotrope ; et
une étape de séparation de phases consistant à amener une couche de composé organique semi-conducteur et une couche de composé à cristaux liquides à subir une séparation de phases lamellaires dans une direction parallèle à une surface du substrat en refroidissant le film organique de telle sorte que le composé organique semi-conducteur est cristallisé, dans cet ordre.

**5.** Procédé pour fabriquer un cristal organique semi-conducteur selon la revendication 4, comprenant en outre : une étape de polymérisation consistant à polymériser la couche de composé à cristaux liquides de telle sorte que la couche est fixée.

**6.** Transistor organique à effet de champ selon l'une quelconque des revendications 1 à 3, comprenant en outre :

une électrode grille ;
une électrode source ;
une électrode déversoir ;
une couche d'isolation de grille isolant l'électrode source et l'électrode déversoir de l'électrode grille, et
un substrat les supportant.

FIG. 1

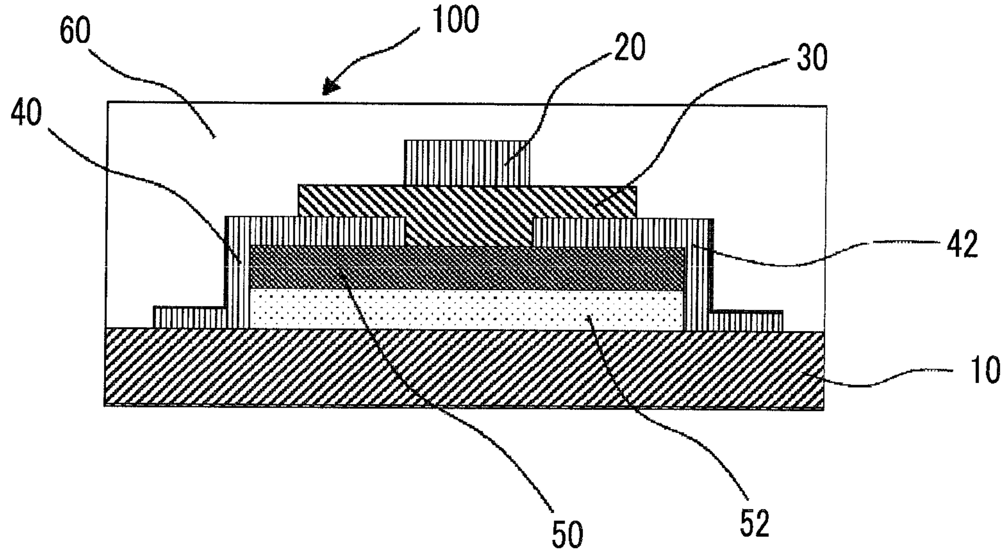


FIG. 2

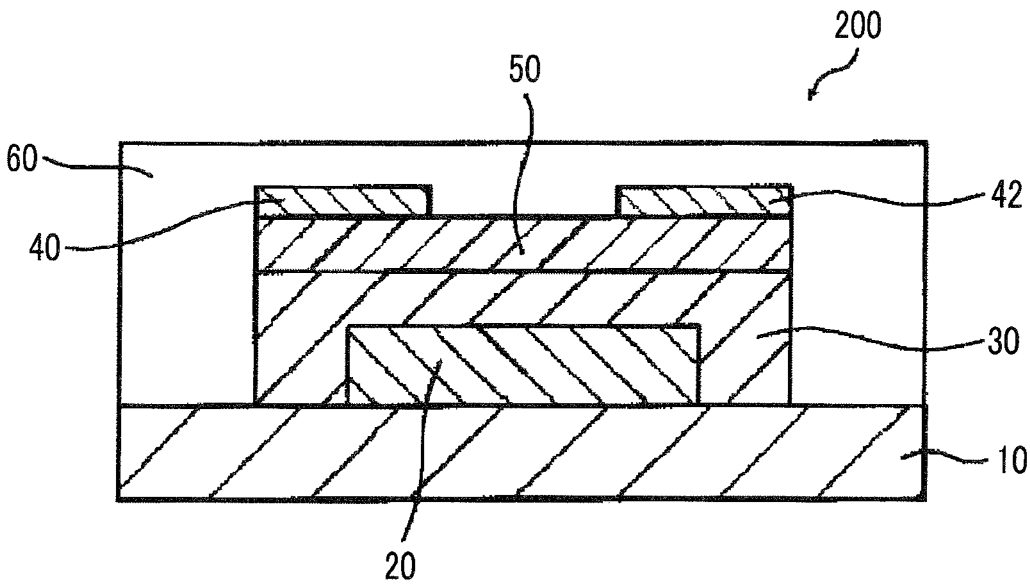

FIG. 3

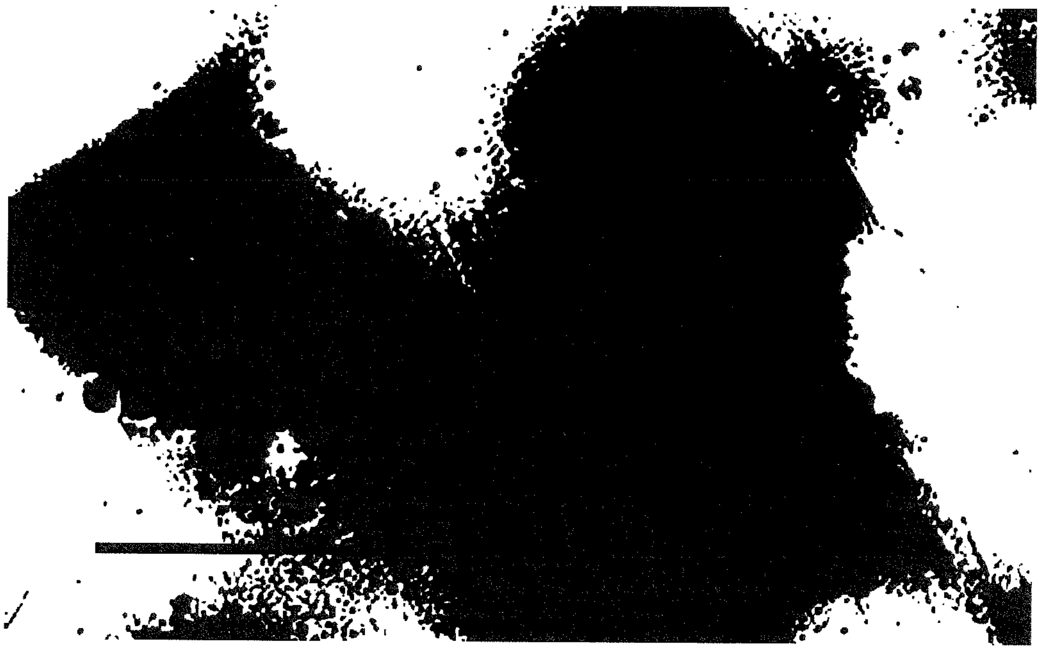

FIG. 4

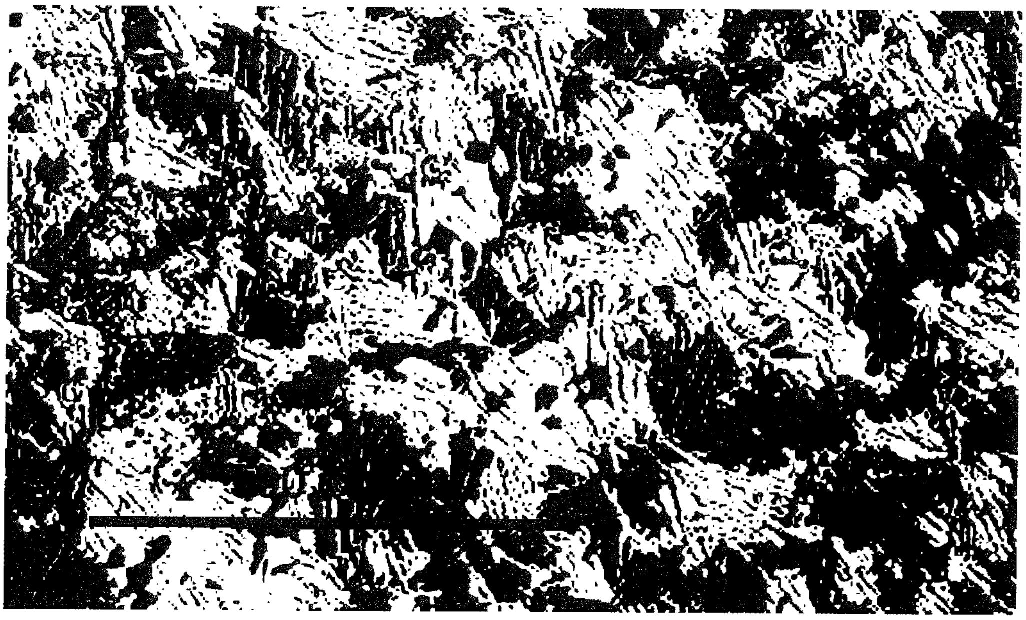

FIG. 5

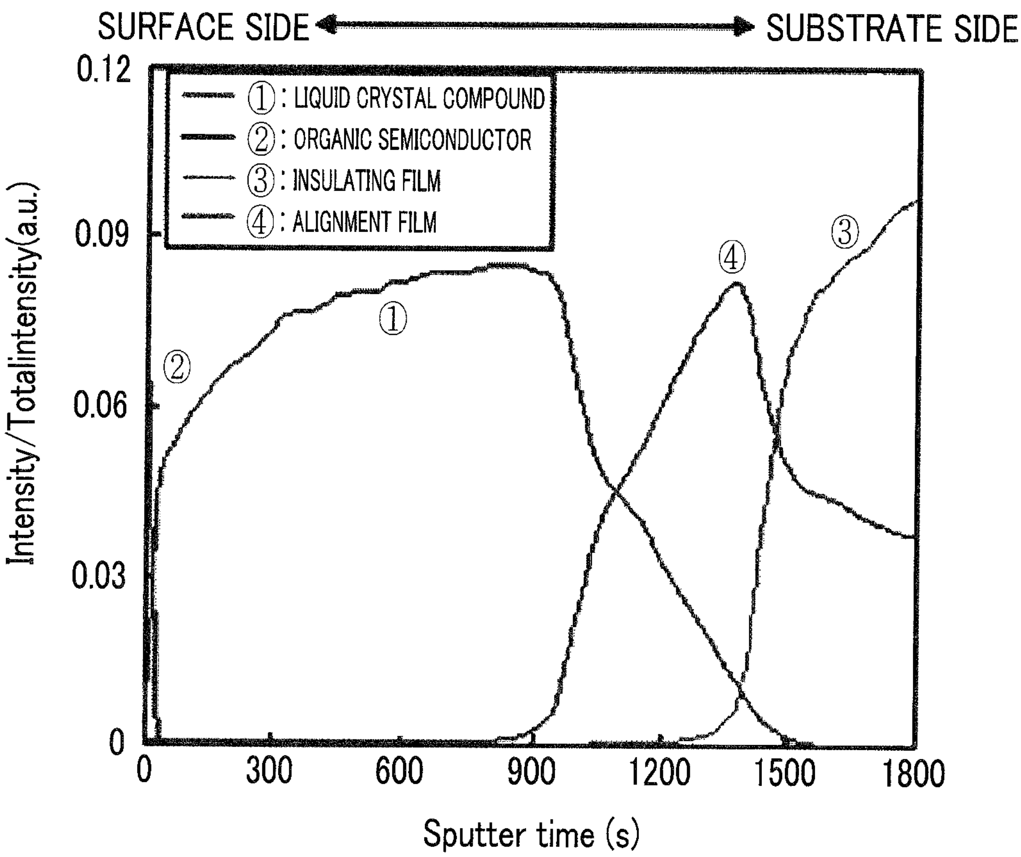
SURFACE SIDE
SUBSTRATE SIDE
①: LIQUID CRYSTAL COMPOUND
②: ORGANIC SEMICONDUCTOR
③: INSULATING FILM
④: ALIGNMENT FILM
Intensity/Totalintensity(a.u.)
0.12
0.09
0.06
0.03
0
0
300
600
900
1200
1500
1800
Sputter time (s)
①
②
③
④

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004031458 A
- WO 2005043639 A
- EP 2197033 A1
- EP 1737027 A1
- JP 8027284 A
- JP H0827284 A
- JP 2009097002 A
- JP 2007108732 A
- US 4683327 A
- US 5622648 A
- US 5770107 A
- WO 9522586 A
- WO 9524455 A
- WO 9700600 A
- WO 9823580 A
- WO 9852905 A
- JP 1272551 A
- JP H01272551 A
- JP 6016616 A
- JP H0616616 A
- JP 7110469 A
- JP H07110469 A
- JP 11080081 A
- JP H1180081 A
- JP 2001328973 A


### Non-patent literature cited in the description


- *Organic Electronics,* 2009, vol. 10, 1097-1101
- *J. Am. Chem. Soc.,* 2009, vol. 131, 6124-6132
- *J. Mater. Chem.,* 2003, vol. 13, 2436-2444
- *Nature Mater.,* 2006, vol. 5, 328-333
- **C. DESTRADE.** Mol. Crysr. Liq. Cryst. 1981, vol. 71, 111
- Chemistry of Liquid Crystal. 1994
- **B. KOHNE et al.** *Angew, Chem. Soc. Chem. Comm.,* 1985, 1794
- **J. ZHANG et al.** *J. Am. Chem. Soc.,* 1994, vol. 116, 2655
- *Makromol. Chem.,* 1989, vol. 190, 2255
- *Advanced Materials,* 1993, vol. 5, 107
- Liquid Crystal Handbook. MARUZEN Co., Ltd, 30 October 2000, 226-229
- *Tetrahedron,* 2010, vol. 66, 8778-8784